# EUROPEAN PATENT APPLICATION

(11) **EP 4 765 637 A1**
(43) Date of publication of application: **24.06.2026**
(21) Application number: 24222247.9
(22) Date of filing: 20.12.2024
(51) Int. Cl.: H03H 17/00, H04B 1/00, H04B 1/68

(54) **RADIO FREQUENCY COMMUNICATION CIRCUITS AND METHODS**

(71) Applicant: INTEL Corporation, Santa Clara, CA 95054 (US)
(72) Inventor: DEGANI, Ofir, 22801 Nes-Ammin (IL); BANIN, Elan, 43606 Raanana M (IL); BEN-BASSAT, Assaf, 3440306 Haifa HA (IL); SKLIAR, Phillip, 5849247 Holon (IL); BOROKHOVICH, Eli, 7176409 Modiin-Maccabim-Reut (IL)
(74) Representative: Viering, Jentschura & Partner mbB Patent- und Rechtsanwälte

(57) **Abstract**

A circuitry may include: a first digital-to-time converter, DTC, configured to generate a first output signal by sampling a phase modulation command signal; a second DTC configured to generate a second output signal based on the phase modulation command signal with a programmable delay relative to the first output signal; and a phase inverter configured to invert a phase of one of the first output signal or the second output signal.

## Description

### Background

In radio communication networks in accordance with many radio communication technologies, such as wireless local area network (WLAN or Wi-Fi), Bluetooth, fourth generation long term evolution (LTE), and fifth generation (5G) new radio (NR), various methods are employed to provide wireless data transfer with desired efficiency, speed, and reliability. These networks require robust design and implementation of radio frequency (RF) components to achieve desired performance characteristics, including low power consumption, high bandwidth, and minimal interference. As wireless communication technologies evolve to meet the growing demand for data and mobile applications, the need for efficient and scalable RF solutions may have become critical.

The need for robust and compact transmitter circuits may be particularly evident in systems like the digital polar transmitter (DPTX) architecture. This architecture may have become a sustainable choice in modern wireless communication systems, as the architecture may utilize digital signal processing techniques to improve power efficiency and scalability. However, as communication systems move toward higher data rates and wider bandwidths, the complexity of these systems also increases. It may be desirable to maintain or enhance performance while reducing complexity.

### Brief Description of the Drawings

In the drawings, like reference characters generally refer to the same parts throughout the different views. The drawings are not necessarily to scale, emphasis instead generally being placed upon illustrating the principles described herein. In the following description, various aspects are described with reference to the following drawings, in which:
FIGs. 1 and 2 depict a general network and device architecture for wireless communications and/or sensing operations;
FIG. 3 shows an exemplary illustration of various communication elements of an apparatus for a wireless communication device;
FIG. 4 shows an exemplary illustration of a transmit path of an RF transceiver;
FIG. 5 illustrates a block diagram of an example of a communication circuitry;
FIG. 6 shows an illustrative graph example of a magnitude response of a communication circuitry;
FIG. 7 shows a block diagram of a circuitry;
FIG. 8 illustrates a circuit diagram of a DPA cell within a digital power amplifier;
FIG. 9 illustrates a schematic example of a shift register;
FIG. 10 illustrates a schematic example of a shift register;
FIG. 11 shows an exemplary illustration of an RF transceiver including a circuitry;
FIG. 12 illustrates an example graph of the magnitude response versus frequency;
FIG. 13 shows an example of a method;
FIG. 14 shows an example of a method.

### Description

The following detailed description refers to the accompanying drawings that show, by way of illustration, exemplary details and aspects in which aspects described herein may be practiced.

In radio communication networks that utilize various radio communication technologies, achieving wireless data transfer with desired efficiency, speed, and reliability is essential. These networks may employ multiple methods to meet the increasing demand for high-speed data transmission while maintaining low power consumption and minimal interference. RF communication circuits form the backbone of these networks, enabling the transmission and reception of wireless signals across different frequencies and bands. Specifically, in the case of transmitter designs in wireless communication networks, it is desirable to maintain the integrity of the transmitted signal and minimize out-of-band noise. Out-of-band noise can impact the quality of the communication signal, which may lead to interference with adjacent channels or even other wireless communication devices.

The transmission architectures has been transformed into distinct RF transmitter designs including the digital transmitter architectures. These architectures can leverage digital signal processing for enhanced efficiency and scalability. Unlike traditional analog transmitters, which may rely on quadrature modulation and analog power amplifiers, the digital polar transmitters may utilize components such as digital-to-time Converters (DTCs) and digital power amplifiers (DPAs). These components can enable precise modulation of phase and amplitude, which may make them particularly suitable for wideband applications with stringent performance requirements. To address these issues, one proposed technique may be the use of transmitter finite impulse response (Tx-FIR) filters. These filters may provide programmable control over out-of-band noise through programmable filtering. A Tx-FIR can be implemented in a compact, silicon-integrated way, which may result in reducing the need for expensive external filters and providing the flexibility to adjust the filter characteristics as needed.

In the implementation of a Tx-FIR in a transmitter, the characterization of the filtering provided by the Tx-FIR may include frequency or frequencies which the Tx-FIR attenuates. This frequency (or frequencies) may be referred to as the notch frequency. In some examples, the programmable nature of a FIR filter (e.g. Tx-FIR) may be implemented through programming the notch frequency, which may be provided by adjusting the delay between the branches of the FIR filter. In various examples, the resolution of the notch frequency may be limited by the precision of the delay values that can be implemented by those branches. Specifically, when the delay is limited to integer values, the notch frequency resolution may become coarse, which may lead to reduced filter performance, especially in the case of fine-grained frequency requirements. This may result in a limitation in terms of filtering performance, especially when attempting to design systems that must meet increasingly stringent performance specifications for wideband applications.

In some examples, a FIR filter may implement a fractional delay technique, which may enable finer control over the notch frequency over the use of integer delays, which may improve the filtering resolution. It is to be noted that fractional delays may work well in systems with uniform sampling, such as digital in-phase quadrature phase (IQ) transmitter architectures. On the other hand, digital polar transmitters may not rely on uniform sampling, which can complicate the application of fractional delay techniques in this context. The mathematical and structural differences between these architectures may further complicate the application of fractional delay techniques. Furthermore, introducing fractional delays into digital polar transmitters may require significant modifications to the DPA and DTC components. Existing solutions often introduce additional overhead, which can contradict the primary goal of simplifying transmitter design for practical implementation in silicon-integrated systems.

Various aspects described herein that may include to enhance the resolution of the notch frequency in polar DPTX systems by implementing fractional delays. In some aspects, the resolution enhancement may include a use of linear interpolation technique, which can offer a practical and efficient way to achieve finer control over notch frequencies without introducing substantial complexity or overhead costs. Additionally, the proposed solution may include configurations of DPA (e.g. switched capacitor power amplifier (SCPA)) cells along with the DTCs, which may enable them to handle the mathematical intricacies associated with fractional delays.

Aspects described herein may align with various RF communication systems, especially where increasing data rates and higher-order modulation schemes may demand innovative solutions to maintain performance across wide frequency ranges. By integrating fractional delay techniques with minimal hardware changes, aspects described herein may contribute to the development of scalable, cost-effective, and high-performance transmitter systems suitable for next-generation wireless networks.

As described herein, a digital-to-time converter may refer to a circuit structure including a first node configured for signal processing, a second node configured to receive a reference signal, a digital-to-analog signal converter section configured to process digital control words, a configurable impedance network selectively coupled to the first node, a switching circuit arrangement having a first switch coupled to the reference signal and a second switch coupled to a reset voltage level, a comparator circuit coupled to an output stage, a capacitive element configured for timing control, and a current source configured for edge timing control, wherein the described structure is configured to receive digital control words representing desired phase modulation parameters, process a reference clock signal from a local oscillator, convert the digital input code into corresponding time delays, generate timing-adjusted output signals with controlled edge transitions, and provide phase-modulated output suitable for driving RF stages, such that the structure performs time-domain conversion of digital input signals into precisely controlled timing variations of an output signal.

As described herein, a phase inverter may refer to an electronics structure which may illustratively include a plurality of semiconductor switching elements arranged in half-bridge configurations, specifically including: a first group of semiconductor switches (Q1, Q3, Q5) forming an upper switch group, a second group of semiconductor switches (Q4, Q6, Q2) forming a lower switch group, wherein each switch may be implemented as a metal-oxide-semiconductor field-effect transistor (MOSFET). Additionally, or alternatively, digital logic circuit structure including one or more gates may be configured as a phase inverter. Specifically, an exclusive-NOR (XNOR) gate that is configured to perform logical operations resulting in a 180-degree phase shift of the input signal may be implemented as a phase inverter.

A digital power amplifier may refer to a circuit structure including switching elements arranged for RF signal amplification. Common implementations may include RF-DAC configurations utilizing switched capacitor arrays with binary-weighted capacitors and digital control logic for capacitor switching, and switched capacitor power amplifier (SCPA) implementations featuring H-bridge configurations of semiconductor switches coupled with capacitor arrays for charge-domain signal processing and digital decoder/encoder blocks for switch control. Additional structural variants may include Class-G implementations with dual power supply voltages, quadrature SCPA structures that combine I/Q signals on shared capacitor arrays, digital polar architectures incorporating envelope and phase processing, and Doherty configurations utilizing carrier and peaking amplifiers. These structures may typically incorporate protection circuits and may be integrated with digital control circuitry implemented in FPGAs or dedicated silicon for enhanced functionality and control.

A phase unwrapper may refer to a digital circuit structure that may include phase detection logic implemented through comparator circuits for detecting phase jumps, arithmetic units including adder/subtractor networks for performing phase corrections by adding or subtracting multiples of 2π, accumulator registers for tracking wrap count, and state machines for controlling phase adjustment operations, wherein common structural implementations include FFT-based processing units, Laplacian operator circuits, look-up tables for storing phase correction values, and digital signal processors with dedicated phase tracking algorithms. The structure may typically include input buffering stages for storing adjacent phase samples, threshold comparison circuits for detecting wrap events, and arithmetic logic units for performing phase corrections to maintain signal continuity across phase transitions.

A linear interpolator may refer to a digital circuit structure including input registers for storing adjacent signal samples, multipliers for applying weighting factors, and an adder network for computing weighted sums. Common implementations may include multiplexer-based architectures with fixed-point arithmetic units and ROM-based lookup tables for coefficient storage, zero-order hold circuits with subsequent filtering stages, binary-weighted summing networks utilizing shift-and-add circuits for power-of-two scaling, and phase accumulator-based structures commonly found in direct digital synthesis applications. Alternative implementations may include resistor networks for analog interpolation, CMOS inverter-based interpolation circuits with resistive summation, or DSP-based implementations utilizing multiply-accumulate units, where these structures typically incorporate input buffering stages, coefficient storage elements, and output conditioning circuits to maintain signal integrity and timing requirements.

The apparatuses and methods described herein may utilize or be related to radio communication technologies. While some examples may refer to specific radio communication technologies, the examples provided herein may be similarly applied to various other radio communication technologies, both existing and not yet formulated, particularly in cases where such radio communication technologies share similar features as disclosed regarding the following examples. Various exemplary radio communication technologies that the apparatuses and methods described herein may utilize include, but are not limited to: a Global System for Mobile Communications ("GSM") radio communication technology, a General Packet Radio Service ("GPRS") radio communication technology, an Enhanced Data Rates for GSM Evolution ("EDGE") radio communication technology, and/or a Third Generation Partnership Project ("3GPP") radio communication technology, for example Universal Mobile Telecommunications System ("UMTS"), Freedom of Multimedia Access ("FOMA"), 3GPP Long Term Evolution ("LTE"), 3GPP Long Term Evolution Advanced ("LTE Advanced"), Code division multiple access 2000 ("CDMA2000"), Cellular Digital Packet Data ("CDPD"), Mobitex, Third Generation (3G), Circuit Switched Data ("CSD"), High-Speed Circuit-Switched Data ("HSCSD"), Universal Mobile Telecommunications System ("Third Generation") ("UMTS (3G)"), Wideband Code Division Multiple Access (Universal Mobile Telecommunications System) ("W-CDMA (UMTS)"), High Speed Packet Access ("HSPA"), High-Speed Downlink Packet Access ("HSDPA"), High-Speed Uplink Packet Access ("HSUPA"), High Speed Packet Access Plus ("HSPA+"), Universal Mobile Telecommunications System-Time-Division Duplex ("UMTS-TDD"), Time Division-Code Division Multiple Access ("TD-CDMA"), Time Division-Synchronous Code Division Multiple Access ("TD-CDMA"), 3rd Generation Partnership Project Release 8 (Pre-4th Generation) ("3GPP Rel. 8 (Pre-4G)"), 3GPP Rel. 9 (3rd Generation Partnership Project Release 9), 3GPP Rel. 10 (3rd Generation Partnership Project Release 10) , 3GPP Rel. 11 (3rd Generation Partnership Project Release 11), 3GPP Rel. 12 (3rd Generation Partnership Project Release 12), 3GPP Rel. 13 (3rd Generation Partnership Project Release 13), 3GPP Rel. 14 (3rd Generation Partnership Project Release 14), 3GPP Rel. 15 (3rd Generation Partnership Project Release 15), 3GPP Rel. 16 (3rd Generation Partnership Project Release 16), 3GPP Rel. 17 (3rd Generation Partnership Project Release 17), 3GPP Rel. 18 (3rd Generation Partnership Project Release 18), 3GPP 4G, 3GPP LTE Extra, LTE-Advanced Pro, LTE Licensed-Assisted Access ("LAA"), MuLTEfire, UMTS Terrestrial Radio Access ("UTRA"), Evolved UMTS Terrestrial Radio Access ("E-UTRA"), Long Term Evolution Advanced (4th Generation) ("LTE Advanced (4G)"), cdmaOne ("2G"), Code division multiple access 2000 (Third generation) ("CDMA2000 (3G)"), Evolution-Data Optimized or Evolution-Data Only ("EV-DO"), Advanced Mobile Phone System (1st Generation) ("AMPS (1G)"), Total Access Communication arrangement/Extended Total Access Communication arrangement ("TACS/ETACS"), Digital AMPS (2nd Generation) ("D-AMPS (2G)"), Push-to-talk ("PTT"), Mobile Telephone System ("MTS"), Improved Mobile Telephone System ("IMTS"), Advanced Mobile Telephone System ("AMTS"), OLT (Norwegian for Offentlig Landmobil Telefoni, Public Land Mobile Telephony), MTD (Swedish abbreviation for Mobiltelefonisystem D, or Mobile telephony system D), Public Automated Land Mobile ("Autotel/PALM"), ARP (Finnish for Autoradiopuhelin, "car radio phone"), NMT (Nordic Mobile Telephony), High capacity version of NTT (Nippon Telegraph and Telephone) ("Hicap"), Cellular Digital Packet Data ("CDPD"), Mobitex, DataTAC, Integrated Digital Enhanced Network ("iDEN"), Personal Digital Cellular ("PDC"), Circuit Switched Data ("CSD"), Personal Handy-phone System ("PHS"), Wideband Integrated Digital Enhanced Network ("WiDEN"), iBurst, Unlicensed Mobile Access ("UMA"), also referred to as also referred to as 3GPP Generic Access Network, or GAN standard), Zigbee, Bluetooth^{®}, Wireless Gigabit Alliance ("WiGig") standard, mmWave standards in general (wireless systems operating at 10-300 GHz and above such as WiGig, IEEE 802.11ad, IEEE 802.11ay, etc.), technologies operating above 300 GHz and THz bands, (3GPP/LTE based or IEEE 802.11p and other) Vehicle-to-Vehicle ("V2V") and Vehicle-to-X ("V2X") and Vehicle-to-Infrastructure ("V2I") and Infrastructure-to-Vehicle ("12V") communication technologies, 3GPP cellular V2X, DSRC (Dedicated Short Range Communications) communication arrangements such as Intelligent-Transport-Systems, and other existing, developing, or future radio communication technologies.

The apparatuses and methods described herein may use such radio communication technologies according to various spectrum management schemes, including, but not limited to, dedicated licensed spectrum, unlicensed spectrum, (licensed) shared spectrum (such as LSA = Licensed Shared Access in 2.3-2.4 GHz, 3.4-3.6 GHz, 3.6-3.8 GHz and further frequencies and SAS = Spectrum Access System in 3.55-3.7 GHz and further frequencies), and may use various spectrum bands including, but not limited to, IMT (International Mobile Telecommunications) spectrum (including 450-470 MHz, 690-960 MHz, 1710-2025 MHz, 2110-2200 MHz, 2300-2400 MHz, 2500-2690 MHz, 698-790 MHz, 610-790 MHz, 3400-3600 MHz, etc., where some bands may be limited to specific region(s) and/or countries), IMT-advanced spectrum, IMT-2020 spectrum (expected to include 3600-3800 MHz, 3.5 GHz bands, 600 MHz bands, bands within the 24.25-86 GHz range, etc.), spectrum made available under FCC's "Spectrum Frontier" 4G initiative (including 27.5-28.35 GHz, 29.1-29.25 GHz, 31-31.3 GHz, 37-38.6 GHz, 38.6-40 GHz, 42-42.5 GHz, 47-64 GHz, 64-71 GHz, 61-76 GHz, 81-86 GHz and 92-94 GHz, etc.), the ITS (Intelligent Transport Systems) band of 4.9 GHz (typically 4.85-5.925 GHz) and 63-64 GHz, bands currently allocated to WiGig such as WiGig Band 1 (57.24-59.40 GHz), WiGig Band 2 (59.40-61.56 GHz) and WiGig Band 3 (61.56-63.72 GHz) and WiGig Band 4 (63.72-65.88 GHz), the 60.2 GHz-71 GHz band, any band between 65.88 GHz and 61 GHz, bands currently allocated to automotive radar applications such as 66-81 GHz, and future bands including 94-300 GHz and above. Furthermore, the apparatuses and methods described herein can also employ radio communication technologies on a secondary basis on bands such as the TV White Space bands (typically below 690 MHz) where e.g. the 400 MHz and 600 MHz bands are prospective candidates. Besides cellular applications, specific applications for vertical markets may be addressed such as PMSE (Program Making and Special Events), medical, health, surgery, automotive, low-latency, drones, etc. applications. Furthermore, the apparatuses and methods described herein may also use radio communication technologies with a hierarchical application, such as by introducing a hierarchical prioritization of usage for different types of users (e.g., low/medium/high priority, etc.), based on a prioritized access to the spectrum e.g., with highest priority to tier-1 users, followed by tier-2, then tier-3, etc. users, etc. The apparatuses and methods described herein can also use radio communication technologies with different Single Carrier or OFDM flavors (CP-OFDM, SC-FDMA, SC-OFDM, filter bank-based multicarrier (FBMC), OFDMA, etc.) and e.g. 3GPP NR (New Radio), which can include allocating the OFDM carrier data bit vectors to the corresponding symbol resources.

Radio communication technologies described herein may be classified as one of a short range radio communication technology or cellular wide area radio communication technology. Short range radio communication technologies may include Bluetooth, WLAN (e.g., according to any IEEE 802.11 standard), and other similar radio communication technologies. Cellular Wide Area radio communication technologies may include Global System for Mobile Communications ("GSM"), Code Division Multiple Access 2000 ("CDMA2000"), Universal Mobile Telecommunications System ("UMTS"), Long Term Evolution ("LTE"), General Packet Radio Service ("GPRS"), Evolution-Data Optimized ("EV-DO"), Enhanced Data Rates for GSM Evolution ("EDGE"), High Speed Packet Access (HSPA; including High Speed Downlink Packet Access ("HSDPA"), High Speed Uplink Packet Access ("HSUPA"), HSDPA Plus ("HSDPA+"), and HSUPA Plus ("HSUPA+")), Worldwide Interoperability for Microwave Access ("WiMax") (e.g., according to an IEEE 802.16 radio communication standard, e.g., WiMax fixed or WiMax mobile), etc., and other similar radio communication technologies. Cellular wide area radio communication technologies also include "small cells" of such technologies, such as microcells, femtocells, and picocells. Cellular wide area radio communication technologies may be generally referred to herein as "cellular" communication technologies.

In the context of WLAN, the apparatuses and methods described herein may be for various wireless devices, including access points (APs) and wireless station devices (STAs), each may be equipped with RF communication capabilities. These devices may incorporate transmission and reception components designed to handle RF signals within specified bandwidths and channels as described herein. The communication components typically include both hardware elements and software implementations for signal processing, enabling modulation and demodulation according to specified communication protocols. These devices may particularly be configured to operate under various wireless communication standards, including those developed by the Institute of Electrical and Electronics Engineers (IEEE) for Wi-Fi applications. The RF components, working in conjunction with antenna systems, enable communication across multiple frequency bands. These frequency bands may include, among others, the 2.4 GHz band supporting protocols such as IEEE 802.11b/g/n/ax, the 5 GHz band supporting IEEE 802.11n/ac/ax/be, and the 6 GHz band supporting newer standards like IEEE 802.11ax/be. Additional operational frequencies may extend to 60 GHz (supporting IEEE 802.11ad/ay) and 800 MHz (supporting IEEE 802.11ah), with antenna systems capable of operating at frequencies such as 28 GHz and 40 GHz. Beyond these specified standards, the devices may support emerging Wi-Fi protocols and alternative wireless communication technologies. These alternatives may include, but are not limited to, Bluetooth technology, dedicated short-range communication systems, Ultra-High Frequency applications (including IEEE 802.11af and IEEE 802.22), and white band frequency utilization. The RF reception chain may typically incorporate essential components such as low noise amplifiers, signal amplification stages, analog-to-digital conversion systems, data buffering mechanisms, and digital baseband processing units, all configured to ensure effective wireless communication capabilities.

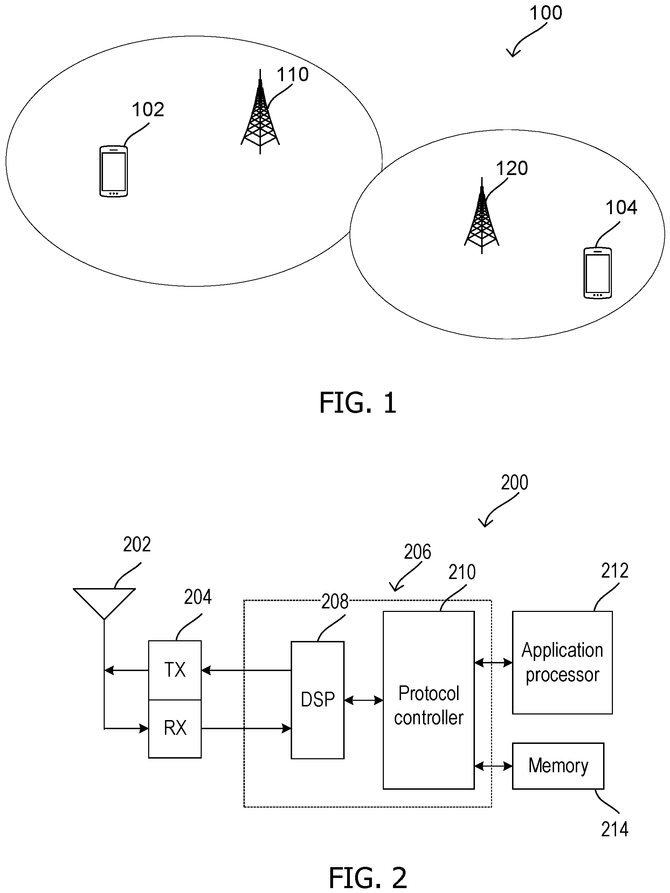

FIGs. 1 and 2 depict a general network and device architecture for wireless communications and/or sensing operations. In particular, FIG. 1 shows exemplary radio communication network 100 according to some aspects, which may include terminal devices 102 and 104 and network access nodes 110 and 120 (e.g. radio access nodes). Radio communication network 100 may communicate with terminal devices 102 and 104 via network access nodes 110 and 120 over a radio access network. Each of terminal devices 102 and 104 or network access nodes 110 and 120 may be a sensing communication device as described herein that may perform a sensing operation. Although certain examples described herein may refer to a particular radio access network context (e.g., 6G, 5G NR, LTE, UMTS, GSM, other 3rd Generation Partnership Project (3GPP) networks, WLAN/WiFi, Bluetooth, millimeter wave, etc.), these examples are demonstrative and may therefore be readily applied to any other type or configuration of radio access network. The number of network access nodes and terminal devices in radio communication network 100 is exemplary and is scalable to any amount.

In an exemplary cellular context, network access nodes 110 and 120 may be base stations (e.g., eNodeBs, NodeBs, Base Transceiver Stations (BTSs), gNodeBs, or any other type of base station), while terminal devices 102 and 104 may be cellular terminal devices (e.g., Mobile Stations (MSs), User Equipments (UEs), or any type of cellular terminal device). Network access nodes 110 and 120 may therefore interface (e.g., via backhaul interfaces) with a cellular core network such as an Evolved Packet Core (EPC, for LTE), Core Network (CN, for UMTS), or other cellular core networks, which may also be considered part of radio communication network 100. The cellular core network may interface with one or more external data networks. In an exemplary short-range context, network access node 110 and 120 may be access points (APs, e.g., WLAN or WiFi APs), while terminal device 102 and 104 may be short range terminal devices (e.g., stations (STAs)). Network access nodes 110 and 120 may interface (e.g., via an internal or external router) with one or more external data networks. Network access nodes 110 and 120 and terminal devices 102 and 104 may include one or multiple transmission/reception points (TRPs).

Network access nodes 110 and 120 (and, optionally, other network access nodes of radio communication network 100 not explicitly shown in FIG. 1) may accordingly provide a radio access network to terminal devices 102 and 104 (and, optionally, other terminal devices of radio communication network 100 not explicitly shown in FIG. 1). In an exemplary cellular context, the radio access network provided by network access nodes 110 and 120 may enable terminal devices 102 and 104 to wirelessly access the core network via radio communications. The core network may provide switching, routing, and transmission, for traffic data related to terminal devices 102 and 104, and may further provide access to various internal data networks (e.g., control nodes, routing nodes that transfer information between other terminal devices on radio communication network 100, etc.) and external data networks (e.g., data networks providing voice, text, multimedia (audio, video, image), and other Internet and application data). Furthermore, terminal devices 102 and 104 and network access nodes 110 and 120 may perform a sensing operation, particularly radar sensing, in accordance with JCAS architecture. In an exemplary short-range context, the radio access network provided by network access nodes 110 and 120 may provide access to internal data networks (e.g., for transferring data between terminal devices connected to radio communication network 100) and external data networks (e.g., data networks providing voice, text, multimedia (audio, video, image), and other Internet and application data).

In accordance with various aspects described herein, network access nodes 110 and 120 and terminal devices 102 and 104 performing their respective sensing operations in a manner, such that each device may perform its respective sensing operation according to its respective sensing signal configuration. Accordingly, each of these devices may generate and transmit its respective sensing signals according to a respective configuration that may include at least one of frequency resources used to transmit sensing signals, the bandwidth of the sensing signals, transmit power of the sensing signals, and waveform shape of the sensing signals which the respective device may determine before generating and/or transmitting the sensing signals. In some examples, a central orchestrator (e.g. a sensing orchestrator) may determine a respective sensing signal configuration for each device and send information representing the respective sensing signal configuration to the respective device.

The radio access network and core network (if applicable, such as for a cellular context) of radio communication network 100 may be governed by communication protocols that can vary depending on the specifics of radio communication network 100. Such communication protocols may define the scheduling, formatting, and routing of both user and control data traffic through radio communication network 100, which includes the transmission and reception of such data through both the radio access and core network domains of radio communication network 100. Accordingly, terminal devices 102 and 104 and network access nodes 110 and 120 may follow the defined communication protocols to transmit and receive data over the radio access network domain of radio communication network 100, while the core network may follow the defined communication protocols to route data within and outside of the core network. Exemplary communication protocols include 6G, 5GNR, LTE, UMTS, GSM, WiMAX, Bluetooth, WiFi, mmWave, etc., any of which may be applicable to radio communication network 100.

FIG. 2 shows an exemplary internal configuration of a communication device (e.g. a sensing communication device) according to various aspects described herein. The communication device may include various aspects of radio communication devices (e.g. network access nodes 110, 120) or various aspects of mobile radio communication devices (e.g. terminal device 102, 104) as well. The communication device 200 may include antenna system 202, radio frequency (RF) transceiver 204, baseband modem 206 (including digital signal processor 208 and protocol controller 210), application processor 212, and memory 214. Although not explicitly shown in FIG. 2, in some aspects communication device 200 may include one or more additional hardware and/or software components, such as processors/microprocessors, controllers/microcontrollers, other specialty or generic hardware/processors/circuits, peripheral device(s), memory, power supply, external device interface(s), subscriber identity module(s) (SIMs), user input/output devices (display(s), keypad(s), touchscreen(s), speaker(s), external button(s), camera(s), microphone(s), etc.), or other related components.

Communication device 200 may transmit and receive radio signals on one or more radio access networks. Baseband modem 206 may direct such communication functionality of communication device 200 according to the communication protocols associated with each radio access network, and may execute control over antenna system 202 and RF transceiver 204 to transmit and receive radio signals according to the formatting and scheduling parameters defined by each communication protocol. Although various practical designs may include separate communication components for each supported radio communication technology (e.g., a separate antenna, RF transceiver, digital signal processor, and controller), for purposes of conciseness the configuration of communication device 200 shown in FIG. 2 depicts only a single instance of such components.

Communication device 200 may transmit and receive wireless signals with antenna system 202. Antenna system 202 may be a single antenna or may include one or more antenna arrays that each include multiple antenna elements. For example, antenna system 202 may include an antenna array at the top of communication device 200 and a second antenna array at the bottom of communication device 200. In some aspects, antenna system 202 may additionally include analog antenna combination and/or beamforming circuitry. In the receive (RX) path, RF transceiver 204 may receive analog radio frequency signals from antenna system 202 and perform analog and digital RF front-end processing on the analog radio frequency signals to produce digital baseband samples (e.g., in-phase/quadrature (IQ) samples) to provide to baseband modem 206. RF transceiver 204 may include analog and digital reception components including amplifiers (e.g., low noise amplifiers (LNAs)), filters, RF demodulators (e.g., RF IQ demodulators), and analog-to-digital converters (ADCs), which RF transceiver 204 may utilize to convert the received radio frequency signals to digital baseband samples. In the transmit (TX) path, RF transceiver 204 may receive digital baseband samples from baseband modem 206 and perform analog and digital RF front-end processing on the digital baseband samples to produce analog radio frequency signals to provide to antenna system 202 for wireless transmission. RF transceiver 204 may thus include analog and digital transmission components including amplifiers (e.g., power amplifiers (PAs), filters, RF modulators (e.g., RF IQ modulators), and digital-to-analog converters (DACs), which RF transceiver 204 may utilize to mix the digital baseband samples received from baseband modem 206 and produce the analog radio frequency signals for wireless transmission by antenna system 202. In some aspects, baseband modem 206 may control the radio transmission and reception of RF transceiver 204, including specifying the transmit and receive radio frequencies for operation of RF transceiver 204.

In accordance with various aspects provided herein, the communication device 200 may perform sensing operations within the radio communication network 100. Illustratively, the baseband modem 206 (e.g. the digital signal processor 208) may be configured to perform sensing-related signal processing in addition to traditional communication processing. For example, the baseband modem 206 may be configured to implement techniques like radar waveform generation, matched filtering for target detection, parameter estimation (e.g., range, velocity, angle) of detected targets, and environmental mapping. In some examples, the baseband modem 206 (e.g. the digital signal processor 208) may use its hardware accelerators and parallel processing capabilities to efficiently handle the computationally intensive sensing algorithms alongside communication tasks.

Furthermore, the baseband modem 206 (e.g. the protocol controller 210) may be configured to coordinate and/or manage joint operation of communication and sensing functions. Illustratively, the baseband modem 206 may schedule sensing and communication operations, allocate resources (e.g., time/frequency resources, antenna beams) between the sensing operations and the communication operations, and manage interference between them. The baseband modem (e.g. the protocol controller 210) may further implement sensing control protocols and interfaces to enable coordination with other network entities for distributed sensing operations as described herein.

In some examples, the application processor 212 may be configured to act as a source and sink for sensing data, similar to its role for communication data. The application processor 212 may execute sensing applications that are configured to process and interpret the sensing data received from the baseband modem 206. Illustratively, the application processor 212 may perform at least one of object detection and tracking, environmental mapping, and/or situational awareness services using the sensing data. In some examples, the application processor 212 may interface with external sensors (e.g., cameras, lidars) to fuse data from multiple sensing modalities for enhanced perception capabilities.

Correspondingly, the RF transceiver 204 may further support the transmission and reception of sensing waveforms in addition to communication signals. Illustratively, the RF transceiver 204 may generate and transmit sensing signals (e.g., frequency-modulated continuous waveforms for radar), and may process the received sensing signals to extract target information. In some examples, the RF transceiver 204 can use the same analog and digital components (e.g., amplifiers, filters, modulators/demodulators, ADCs/DACs) for sensing operations and the communication operations, potentially with additional hardware accelerators for sensing-specific tasks. Illustratively, the antenna system 202 may also support both communication and sensing functions, in some examples with separate antenna arrays or shared arrays with beamforming capabilities. In accordance with various aspects, the antenna system 202 can form narrow beams for extended sensing range or wide beams for faster coverage, depending on the sensing requirements and resource constraints. Techniques like MIMO and beamforming can be employed to enhance the sensing performance and enable features like high-resolution target parameter estimation and interference mitigation.

As shown in FIG. 2, baseband modem 206 may include digital signal processor 208, which may perform physical layer (PHY, layer 1) transmission and reception processing to, in the transmit path, prepare outgoing transmit data provided by protocol controller 210 for transmission via RF transceiver 204, and, in the receive path, prepare incoming received data provided by RF transceiver 204 for processing by protocol controller 210. Digital signal processor 208 may be configured to perform one or more of error detection, forward error correction encoding/decoding, channel coding and interleaving, channel modulation/demodulation, physical channel mapping, radio measurement and search, frequency and time synchronization, antenna diversity processing, power control and weighting, rate matching/de-matching, retransmission processing, interference cancelation, and any other physical layer processing functions. Digital signal processor 208 may be structurally realized as hardware components (e.g., as one or more digitally-configured hardware circuits or field programmable gate arrays (FPGAs)), software-defined components (e.g., one or more processors configured to execute program code defining arithmetic, control, and I/O instructions (e.g., software and/or firmware) stored in a non-transitory computer-readable storage medium), or as a combination of hardware and software components. In some aspects, digital signal processor 208 may include one or more processors configured to retrieve and execute program code that defines control and processing logic for physical layer processing operations. In some aspects, digital signal processor 208 may execute processing functions with software via the execution of executable instructions. In some aspects, digital signal processor 208 may include one or more dedicated hardware circuits (e.g., application specific integrated circuits (ASICs), field programmable gate arrays, and other hardware) that are digitally configured to specific execute processing functions, where the one or more processors of digital signal processor 208 may offload certain processing tasks to these dedicated hardware circuits, which are known as hardware accelerators. Exemplary hardware accelerators can include fast Fourier transform (FFT) circuits and encoder/decoder circuits. In some aspects, the processor and hardware accelerator components of digital signal processor 208 may be realized as a coupled integrated circuit.

Communication device 200 may be configured to operate according to one or more radio communication technologies. Digital signal processor 208 may be responsible for lower-layer processing functions (e.g., layer 1/PHY) of the radio communication technologies, while protocol controller 210 may be responsible for upper-layer protocol stack functions (e.g., data link layer/layer 2 and/or network layer/layer 3). Protocol controller 210 may thus be responsible for controlling the radio communication components of communication device 200 (antenna system 202, RF transceiver 204, and digital signal processor 208) in accordance with the communication protocols of each supported radio communication technology, and accordingly may represent the access stratum (AS) and non-access stratum (NAS) (also encompassing layer 2 and layer 3) of each supported radio communication technology. Protocol controller 210 may be structurally embodied as a protocol processor configured to execute protocol stack software (retrieved from a controller memory) and subsequently control the radio communication components of communication device 200 to transmit and receive communication signals in accordance with the corresponding protocol stack control logic defined in the protocol software. Protocol controller 210 may include one or more processors configured to retrieve and execute program code that defines the upper-layer protocol stack logic for one or more radio communication technologies, which can include data link layer/layer 2 and network layer/layer 3 functions. Protocol controller 210 may be configured to perform both user-plane and control-plane functions to facilitate the transfer of application layer data to and from radio communication device 200 according to the specific protocols of the supported radio communication technology. User-plane functions can include header compression and encapsulation, security, error checking and correction, channel multiplexing, scheduling, and priority, while control-plane functions may include setup and maintenance of radio bearers. The program code retrieved and executed by protocol controller 210 may include executable instructions that define the logic of such functions.

Communication device 200 may also include application processor 212 and memory 214. Application processor 212 may be a CPU, and may be configured to handle the layers above the protocol stack, including the transport and application layers. Application processor 212 may be configured to execute various applications and/or programs of communication device 200 at an application layer of communication device 200, such as an operating system (OS), a user interface (UI) for supporting user interaction with communication device 200, and/or various user applications. The application processor may interface with baseband modem 206 and act as a source (in the transmit path) and a sink (in the receive path) for user data, such as voice data, audio/video/image data, messaging data, application data, basic Internet/web access data, etc. In the transmit path, protocol controller 210 may therefore receive and process outgoing data provided by application processor 212 according to the layer-specific functions of the protocol stack, and provide the resulting data to digital signal processor 208. Digital signal processor 208 may then perform physical layer processing on the received data to produce digital baseband samples, which digital signal processor may provide to RF transceiver 204. RF transceiver 204 may then process the digital baseband samples to convert the digital baseband samples to analog RF signals, which RF transceiver 204 may wirelessly transmit via antenna system 202. In the receive path, RF transceiver 204 may receive analog RF signals from antenna system 202 and process the analog RF signals to obtain digital baseband samples. RF transceiver 204 may provide the digital baseband samples to digital signal processor 208, which may perform physical layer processing on the digital baseband samples. Digital signal processor 208 may then provide the resulting data to protocol controller 210, which may process the resulting data according to the layer-specific functions of the protocol stack and provide the resulting incoming data to application processor 212. Application processor 212 may then handle the incoming data at the application layer, which can include execution of one or more application programs with the data and/or presentation of the data to a user via a user interface.

Memory 214 may embody a memory component of communication device 200, such as a hard drive or another such permanent memory device. Although not explicitly depicted in FIG. 2, the various other components of communication device 200 shown in FIG. 2 may additionally each include integrated permanent and non-permanent memory components, such as for storing software program code, buffering data, etc.

In accordance with some radio communication networks, terminal devices 102 and 104 may execute mobility procedures to connect to, disconnect from, and switch between available network access nodes of the radio access network of radio communication network 100. As each network access node of radio communication network 100 may have a specific coverage area, terminal devices 102 and 104 may be configured to select and re-select available network access nodes to maintain a strong radio access connection with the radio access network of radio communication network 100. For example, terminal device 102 may establish a radio access connection with network access node 110 while terminal device 104 may establish a radio access connection with network access node 112.

In the event the current radio access connection degrades, terminal devices 102 or 104 may seek a new radio access connection with another network access node of radio communication network 100. For example, terminal device 104 may move from the coverage area of network access node 112 into the coverage area of network access node 110. As a result, the radio access connection with network access node 112 may degrade, which terminal device 104 may detect via radio measurements such as signal strength or signal quality measurements of network access node 112.

Depending on the mobility procedures defined in the appropriate network protocols for radio communication network 100, terminal device 104 may seek a new radio access connection (which may be, for example, triggered at terminal device 104 or by the radio access network), such as by performing radio measurements on neighboring network access nodes to determine whether any neighboring network access nodes can provide a suitable radio access connection. As terminal device 104 may have moved into the coverage area of network access node 110, terminal device 104 may identify network access node 110 (which may be selected by terminal device 104 or selected by the radio access network) and transfer to a new radio access connection with network access node 110. Such mobility procedures, including radio measurements, cell selection/reselection, and handover are established in the various network protocols and may be employed by terminal devices and the radio access network in order to maintain strong radio access connections between each terminal device and the radio access network across any number of different radio access network scenarios.

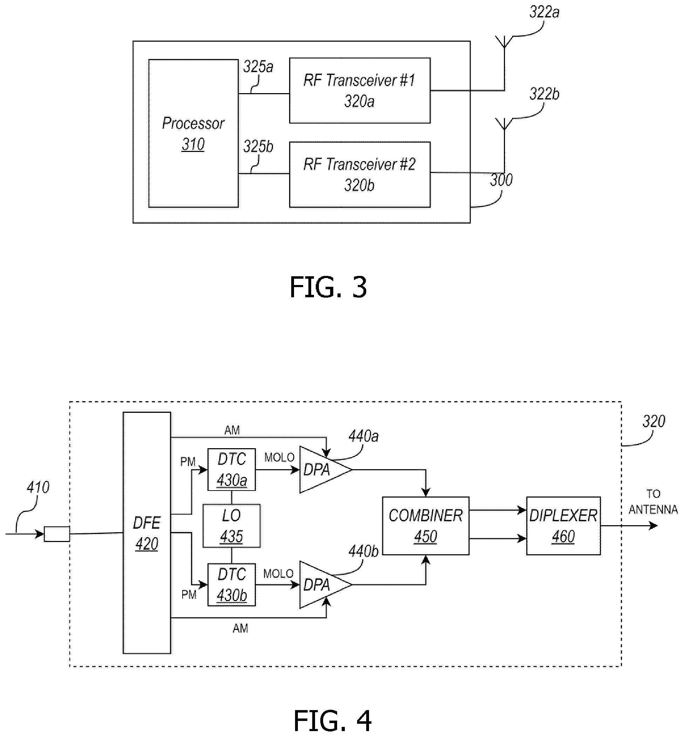

FIG. 3 shows an exemplary illustration of various communication elements of an apparatus for a wireless communication device (e.g. the communication device 200). The apparatus 300 may include processing circuitry 310 (e.g. the baseband modem 206, the application processor 212) that may direct and manage communication operations of the apparatus 300 according to one or more radio communication protocols, and may control transmission/reception of communication signals over at least one or more antenna 322a-b via one or more RF transceivers 320a-b. The processing circuitry 310 may include an interface to the RF transceivers 320a-b. In this example, two RF transceivers, namely a first RF transceiver 320a and a second RF transceiver 320b are illustrated, but the apparatus 300 may include more than two RF transceivers. In an example, each RF transceiver depicted herein may be implemented by a respective integrated circuit (i.e. a transceiver integrated circuit). In accordance with various aspects described herein, the apparatus 300 may include the communication circuitry described herein, which the communication circuitry may include the RF transceivers 320a-b.

Each RF transceiver 320a-b may include at least one RF-chain to process the communication signals associated with the antenna 322a-b respectively. The apparatus 300 may include the first and second antennas 322a-b, or the apparatus 300 may include an antenna interface couplable to these antennas 322a-b. It is to be noted that the apparatus 300 is depicted as being couplable to the antennas 322a-b, but the apparatus 300 may be couplable to more than two antennas, and thereby each RF transceiver 320a-b may include a plurality of RF-chains, each RF-chain may process communication signals for a respective antenna. The apparatus 300 may transmit and receive radio communication signals with the antennas 322a-b. The apparatus 300 may act as an RF transmitter (e.g. RF transmit circuit) to transmit radio communication signals and it may also act as an RF receiver (e.g. RF receive circuit) to receive radio communication signals.

The processing circuitry 310 may include, or may be implemented, partially or entirely, by circuit and/or logic, e.g., a processor including circuit and/or logic, a memory circuit and/or a logic, which may be configured to manage radio communication operations. The processing circuitry 310 may be configured to communicate with an external main processor (e.g. a host processor, a central processing unit, a system on chip) of the wireless communication device including the apparatus 300 via a designated interface that is coupled to the main processor. In some examples, the processing circuitry 310 may be the main processor of the wireless communication device. The processing circuitry 310 may also access the main memory of the respective wireless communication device via the designated interface. The processing circuitry 310 may further include an interface to the RF transceivers 320a-b.

The processing circuitry 310 may include a digital signal processor (e.g. the digital signal processor 208). The digital signal processor 208 may be configured to perform one or more of error detection, forward error correction encoding/decoding, channel coding, and interleaving, channel modulation/demodulation, physical channel mapping, radio measurement and search, frequency and time synchronization, antenna diversity processing, power control, and weighting, rate matching/de-matching, retransmission processing, interference cancelation, and any other physical layer processing functions.

The processing circuitry 310 may include a modem configured to process baseband signals received from/sent to the antennas 322a-b via respective communication paths 325a-b including a corresponding RF chain. In various examples, the interface to the RF transceivers 320a-b of the processing circuitry 310 may be configured to couple the processing circuitry 310 to the communication paths 325a-b. Accordingly, the processing circuitry 310 may include media-access control (MAC) circuit and/or logic, physical layer (PHY) circuit and/or logic, baseband (BB) circuit and/or logic, a baseband processor, a baseband memory, application processor circuit and/or logic, an application processor, an application processor memory, and/or any other circuit and/or logic. By way of example, the processing circuitry 310 can perform baseband processing on the digital baseband signals to recover data included in wireless data transmissions.

The processing circuitry 310 may control and/or arbitrate transmit and/or receive functions of the apparatus 300, and perform one or more baseband processing functions (e.g., MAC, encoding/decoding, modulation/demodulation, data symbol mapping, error correction, etc.). The processing circuitry 310 may be configured to provide control functions to the RF transceivers 320a-b (e.g. to the RF-chain to control and/or arbitrate transmitting and/or receiving radio communication signals). In aspects, functions of processing circuitry 310 can be implemented in software and/or firmware executing on one or more suitable programmable processors, and may be implemented, for example, in a field programmable gate array, application specific integrated circuit, etc. In various examples, the interface to the RF transceivers 320a-b of the processing circuitry 310 may be configured to couple processing circuitry to the RF transceivers 320a-b to provide communication in-between.

Each RF transceiver 320a-b may provide RF processing of communication signals conveyed via a respective communication path 325a-b within a respective RF chain to transmit radio communication signals via a respective antenna based on signals (e.g. baseband communication signals, digital signals) received from the processing circuitry 310 over the communication path. Each RF transceiver 320a-b may provide RF processing of communication signals conveyed via the respective communication path 325a-b to receive radio communication signals via the respective antenna 322a-b and provide signals to the processing circuitry 310 over the respective communication path 325a-b. The processing circuity 310 may be configured to control operations of the RF transceivers 320a-b. Each RF transceiver 320a-b may include a receive path to provide RF processing to receive radio communication signals received from the respective antenna 322a-b, and a transmit path to provide RF processing to transmit radio communication signals transmitted via the respective antenna 322a-b.

In a receive (RX) path, each RF transceiver 320a-b may receive analog radio frequency signals from the respective antenna 322a-b via the respective communication path 325a-b and perform analog and digital RF front-end processing on the analog radio frequency signals to produce digital baseband samples (e.g., In-phase/Quadrature (IQ) samples) to provide to the processing circuitry 310. In various examples, each RF transceiver 320a-b may include two RF-chains per antenna element, each RF-chain may be designated for a particular polarization. Each RF transceiver 320a-b may include analog and digital reception components including amplifiers (e.g., low noise amplifiers (LNAs)), filters, RF demodulators (e.g., RF IQ demodulators)), and analog-to-digital converters (ADCs), which that RF transceiver 320 may utilize to convert the received radio frequency signals to digital baseband samples.

In a transmit (TX) path, each RF transceiver 320a-b may receive digital baseband samples from processing circuitry 310 and perform analog and digital RF front-end processing on the digital baseband samples to produce analog radio frequency signals to be provided to the respective antenna 322a-b via the respective communication path 325a-b for radio transmission. Each RF transceiver 320a-b may thus include analog and digital transmission components including amplifiers (e.g., power amplifiers (PAs), filters, RF modulators (e.g., RF IQ modulators), and digital-to-analog converters (DACs), which that RF transceiver 320 may utilize to mix the digital baseband samples received from processing circuitry 310 and produce respective analog radio frequency signals for radio transmission by the respective antenna 322a-b. In some aspects, the processing circuitry 310 may control the radio transmission and reception of the RF transceivers 320a-b, including specifying the transmit and receive radio frequencies for the operation of each RF transceiver 320a-b. In some examples, at least one of the amplifiers may include an amplifier circuit provided herein.

FIG. 4 shows an exemplary illustration of a transmit path of an RF transceiver. The RF transceiver is referred to here as the RF transceiver 320 and may be the first RF transceiver 320a or the second RF transceiver 320b described in accordance with FIG. 3. The RF transceiver 320, of which its transmit path illustrated herein, may be configured for a digital polar transmitter. The RF transceiver 320 may be couplable to processing circuitry (e.g. the processing circuitry 310, a modem) over an interface. The interface may include a communication path designated to carry communication signals 410 between the processing circuitry and an antenna. In some examples, the interface may include a further circuit path to provide communication between the RF transceiver 320 and the processing circuitry for control of the operations. The RF transceiver 320 may further include further components and or circuits, such as further filter circuits, synthesizer circuits, etc. that are not depicted here. The RF transceiver 320 may include various circuits and components deployed on the respective transmission path.

The RF transceiver 320 may include various circuits and components deployed to process and transmit communication signals across two frequency bands. These components may include a digital front end (DFE) 420, digital to time converters (DTCs) 430a and 430b, digital power amplifiers (DPAs) 440a and 440b, a combiner 450 and a diplexer 460.

The digital front end 420 may receive the communication signals 410 via the interface coupling the processing circuitry to the digital front end 420. The digital front end 420 may include a digital front end processing circuitry and further components. The digital front end 420 may be configured to convert the communication signals 410 (e.g. in-phase/quadrature signals) into a polar signal including an amplitude modulation (AM) signal (e.g. amplitude control codes) which may be referred to as an amplitude modulation command signal herein, and a phase modulation (PM) signal (e.g. phase control codes), which may be referred to as a phase modulation command signal herein. Generated amplitude modulation signals and phase modulation signals may be provided to respective transmit chains for further processing.

Illustratively, in a first transmit signal path, the RF transceiver 320 may include a first digital to time converter 430a. The first digital to time converter 430a may be coupled to the digital front end 420. The first digital to time converter 430a may receive the respective phase modulation signal. The first digital to time converter 430a may be further coupled to a local oscillator (LO) 435. The first digital to time converter 430a may adjust polar modulation parameters (e.g. phase of the oscillator signal) based on the phase modulation signal that the digital front end 420 provides to generate a first modulated local oscillator signal. The first digital to time converter 430a may output a first modulated local oscillator (MOLO) signal. In the first transmit signal path, the RF transceiver 320 may further include a first digital power amplifier 440a. The first digital power amplifier 440a may receive the amplitude modulation signal setting desired power of the output of the first digital power amplifier 440a. The first digital power amplifier 440a may further receive the modulated local oscillator signal and provide a first output RF signal, which is based on the received modulated local oscillator signal and amplitude modulation signal. The first digital power amplifier 440a may include a dynamic power control, or an RF-capacitive digital to analog converter (RF-CDAC).

In a second transmit signal path, the RF transceiver 320 may include a second digital to time converter 430b. The second digital to time converter 430b may be coupled to the digital front end 420. The second digital to time converter 430b may receive the respective phase modulation signal. The second digital to time converter 430b may be further coupled to the local oscillator 435. The second digital to time converter 430b may adjust polar modulation parameters (e.g. phase of the oscillator signal) based on the phase modulation signal that the digital front end 420 provides to generate a second modulated local oscillator signal. The second digital to time converter 430a may output a second modulated local oscillator signal. In the second transmit signal path, the RF transceiver 320 may further include a second digital power amplifier 440b. The second digital power amplifier 440b may receive the amplitude modulation signal setting desired power of the output of the second digital power amplifier 440b. The second digital power amplifier 440b may further receive the second modulated local oscillator signal at the second frequency band and provide a second output RF signal, which is based on the received second modulated local oscillator signal and amplitude modulation signal. The second digital power amplifier 440b may include a dynamic power control, or an RF-capacitive digital to analog converter.

The local oscillator 435 may include various components to generate a stable and continuous signal at one or more designated frequencies, and may serve as a reference for frequency conversion, mixing and other signal processing tasks. In an example, the local oscillator 435 may include an oscillator core. The oscillator core may generate signals at specified frequencies. An oscillator core may include one or more voltage controlled oscillators which may include tunable oscillators whose frequency can be adjusted by varying a control voltage. The oscillator core may include crystal oscillators that may rely on the mechanical resonance of quartz crystals. The oscillator core may include a dielectric resonator oscillators (DROs).

In some examples, the local oscillator 435 may include a resonator to determine or stabilize the frequency of oscillation. The resonator may include quartz crystals in crystal oscillators or LC circuits or dielectric resonators in voltage controller oscillators. In some examples, the local oscillator 435 may further include phase-locked loops (PLLs) to synchronize the output of the local oscillator 435 with a reference signal to facilitate high accuracy and stability with low phase noise. Illustratively, a phase-locked loop may include a reference oscillator, a phase detector, a low-pass filter, and a VCO or a tunable oscillator. The LO 435 may further include a frequency control circuit that is configured to adjust the output frequency of the local oscillator 435 through various methods, such as manual tuning (e.g. potentiometers), automatic frequency control (AFC), or digital control via microcontrollers, or DSPs (e.g. via the digital front end 420). In accordance with various aspects described herein, the LO 435 may operate with a resonator that is shared with another RF transceiver. Illustratively, referring back to FIG. 4, in an example that the RF transceiver 320 is the first RF transceiver 320a, the second RF transceiver 320b may also be a transceiver that is identical or similar to the RF transceiver 320. A common resonator may be shared by LOs (e.g. the LO 435) of these RF transceivers.

The RF transceiver 320 may further include the combiner 450 to combine the RF signals provided by the digital power amplifiers 440a-b. The combiner 450 may be configured to combine RF signals from the first transmit signal path and the second transmit signal path. Specifically, the combiner 450 may couple the RF signals output by the digital power amplifiers 440a and 440b received by the first end (e.g. input) of the combiner 450 to the second end (e.g. output) of the combiner 450 to further components of the RF transceiver 320, which are coupled to the second end of the coupler. The combiner 450 (e.g. a transformer) may facilitate proper impedance matching for both frequency bands to optimize power transfer and minimize signal reflection.

In the above-mentioned constellation of the first transmit signal path, the second transmit signal path, and the combiner may form a Tx-FIR filter. In such a configuration, the frequency response of the Tx-FIR filter may be configurable through adjusting of PM and AM signals to obtain a desired frequency response. In some examples, this configurability may be facilitated by a logic (e.g. a logic circuit, the processor 310 or the DFE 420) to set the respective PM signals and the respective AM signals received by the digital to time converters 430a-b and the digital power amplifiers 440a-b, which may result in attenuation of corresponding frequencies (notch frequencies) at the output of the combiner 450. Illustratively, the respective PM signals received by the digital to time converters 430a-b, may cause the digital to time converters 430a-b to output substantially identical signals with a designated phase difference. Through changing of the phase difference between outputs of the digital to time converters 430a-b, the notch frequency (i.e. attenuation response of the Tx-FIR filter) may be changed. The RF transceiver 320 may further include the diplexer 460 coupled to the outputs of the combiner 450.

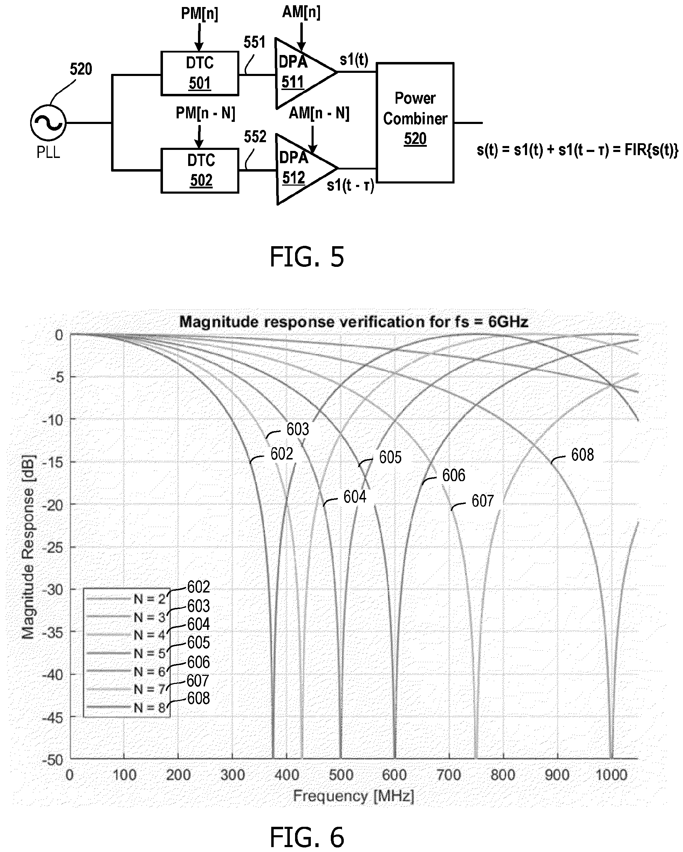

FIG. 5 illustrates a block diagram of a communication circuitry in accordance with aspects described herein. The communication circuitry illustrated herein may be configured for a Tx-FIR filtering operation, which may be implemented in an RF transceiver (e.g. the RF transceiver 320) for digital polar transmission of a communication device.

The circuitry may include a phase-locked loop (PLL) 520, which may be configured to generate a reference oscillator signal. This reference signal may serve as the basis for phase modulation and timing adjustments in the circuitry. The PLL 520 may provide its output to two digital-to-time converters (DTCs): the first DTC 501 and the second DTC 502. These DTCs may be configured to convert digital phase modulation (PM) command signals into modulated time-domain signals to be used in the RF transmission chain.

Illustratively, the first DTC 501 may receive a phase modulation command signal, PM[n], as its input. This command signal may represent information corresponding to the desired phase adjustments. The first DTC 501 may sample the first phase modulation command signal and adjust the phase of the reference oscillator signal received from the PLL 520, which the phase adjusted signal may correspond to the first output signal. The output of the first DTC 501 may be a time-modulated oscillator signal. The first output signal may be sent via the signal path 551 to the first digital power amplifier (DPA) 511.

In parallel, the second DTC 502 may process a delayed version of the phase modulation command signal, PM[n - N]. This delay may be deliberately introduced to enable programmable and fractional adjustments to the phase. In an example, a linear interpolator within the delay circuit of the second DTC 502 may facilitate fractional delays. In an example, the delay circuit may include a shift register to facilitate fractional delays. By enabling fractional delays, the second DTC 502 may achieve precise frequency response configurations for the Tx-FIR filter, particularly for applications requiring narrowband filtering. The second DTC 502 may output a modulated oscillator signal representing the delayed phase-modulated signal. This output may be directed to the second DPA 512 via the signal path 552.

A fractional delay may refer to a sub-integer delay to a signal, to enable finer control over the timing of its propagation. Unlike integer delays, which are configured to shift a signal by discrete time intervals corresponding to the sampling period, a fractional delay may be between sample points, illustratively via an interpolation or a shifting in combination with oversampling, to achieve a delay that is not limited to integer multiples of the sampling interval. Some other fractional delay implementations may include spline interpolation, or more complex digital filtering methods. By allowing adjustments to the relative phase modulation signal timing between phase modulation command signals of the first DTC 501 and the second DTC 502 in a manner that is smaller than the sampling period, fractional delay may facilitate dynamic and programmable fine-tuning of frequency responses, such as creating narrowband notches for out-of-band noise suppression to reduce the need for complex external filters, enable compact, silicon-integrated solutions while maintaining signal quality..

Both DPA 511 and DPA 512 may serve as amplifiers in their respective signal path. These DPAs may receive amplitude modulation (AM) command signals, which may control the power levels of the respective RF output signals. Specifically, the first DPA 511 may amplify the output of the first DTC 501 based on the AM command signal AM[n] to obtain the signal s1(t), while the second DPA 512 may amplify the output of the second DTC 502 using the delayed AM command signal AM[n - N] to obtain the signal s1(t - τ). This dual-path amplification may facilitate that both amplitude and phase parameters are independently configurable for the two RF signals.

A power combiner 520 may combine the outputs of the two DPAs, corresponding to the modulated and amplified signals. The combiner may merge the two RF signals to form a composite output signal s(t). The combiner 520 may accordingly introduce a finite impulse response filtering effect, which may enable programmable attenuation at specific frequencies (notch frequencies), which may be based on the controlling the relative phase and amplitude of the two input signals.

The circuitry may adjust its frequency response dynamically. By changing the relative timing between these two signals paths (e.g. via delay (τ) introduced by the second DTC 502) and modifying the amplitude levels through AM command signals, the system may target specific frequencies for attenuation.

FIG. 6 shows an illustrative graph example of a magnitude response of a communication circuitry configured to implement integer delays in Tx-FIR filtering operation, illustrating the impact of varying integer delays on notch frequency configurability. The x-axis represents frequency in megahertz (MHz), while the y-axis shows the corresponding magnitude response in decibels (dB). The curves labeled 602 through 608 represent different integer values of N, where N is the delay in terms of number of samples applied to the phase modulation command signals between the first and second signal path.

Referring to the circuitry described in accordance with FIG. 5, the first and second digital-to-time converters may operate with an integer delay. This delay may result in a time offset of N/Fₛ where Fₛ may correspond to the sampling rate of the amplitude and phase modulation command signals. Consequently, the circuitry may produce a notch at a frequency offset of Fₛ/2N. The graph highlights the relationship between the value of N and the position of the notch frequencies, with lower values of N (e.g., 602, 603) corresponding to notches at lower frequency offsets, and higher values of N (e.g., 607, 608) creating notches further from the origin. This integer-delay implementation, as evident from the graph, demonstrates that the resolution of the notch frequencies degrades as the frequency offset increases. For example, the curve labeled 602 exhibits narrow spacing between adjacent notches, while higher values of N, such as 608, provide wider-spaced notches, particularly limiting the ability to fine-tune the filter response.

Illustratively, for an integer delay implementation, the PLL 520 may provide an oscillator signal to both DTCs 501 and 502. The first DTC 501 may directly processes the phase modulation command signal PM[n], while the second DTC 502 receives a delayed version of the signal, PM[n-N]. This delay may generate the integer offsets. The outputs of the DTCs 501, 502, modulated by the respective phase modulation commands, are amplified by DPAs 511 and 512, forming two independent signal paths. The power combiner may subsequently merge these signals for the Tx-FIR filtering effect that may correspond to the magnitude response observed in the graph.

In accordance with the first embodiment described herein, the first digital-to-time converter 501 may receive a phase modulation command signal. The DTC 501 may sample this phase modulation command signal to adjust the phase of the reference oscillator signal generated by the phase-locked loop 520. Illustratively, the DTC 501 may include a circuit to facilitate the adjustment of the phase of the reference oscillator signal according to the phase modulation command signal by converting the digital phase command into a time-domain modulated oscillator signal. The resultant first output signal may then propagate along the signal path 551 to additional processing components, such as the first digital power amplifier DPA 511. The sampling process may be synchronized to a designated sampling frequency.

In an example, the second DTC may generate a second output signal based on the same phase modulation command signal, but with a programmable delay relative to the first output signal. For example, a delay circuit coupled to the second DTC 502 may introduce this delay, which may include components such as shift registers. The programmable delay may be represented as τ=N/Fₛ, where N is the integer delay value, and Fₛ is the sampling frequency of the command signals. Illustratively, a controller may modify N to adjust the relative timing of the second output signal to generate specific frequency responses. The second output signal may be routed along signal path 552 for subsequent processing. For example, the oscillator signal received by the DTCs 501, 502 (e.g. the second DTC) may cause the delay circuit (e.g. coupled to the second DTC 502) to oversample the phase modulation command signal, for a finer granularity in the delay configuration.

In accordance with various aspects described herein, the circuitry may include a phase inverter, which may be configured to invert the phase of one of the first output signal from the first DTC 501 or the second output signal from the second DTC 502. In some examples, this inversion may be selectively controlled by a phase inversion control signal, which may be routed to an internal XNOR gate within the DTC (or within the DPA). When enabled, the phase inverter may introduce a 180-degree phase shift in the designated signal to facilitate phase alignment for attenuation or interference cancellation. The phase inverter may also interact with the programmable delay feature, particularly in scenarios involving fractional delays, to correct artifacts that may arise from the delay interpolation process.

To facilitate phase inversion, the circuitry may be provided with a precise control of the phase inversion state, which may be achieved through a dedicated controller or logic circuit. For example, a control signal may indicate whether phase inversion is enabled or disabled based on the operational context, such as whether the system is operating in fractional delay or integer delay mode.

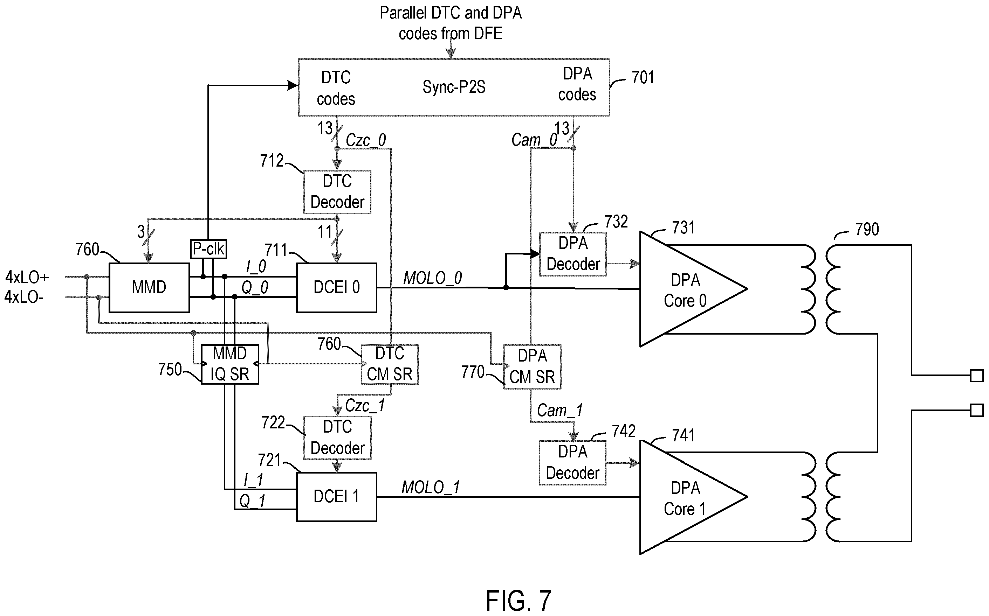

FIG. 7 shows a block diagram of a circuitry in accordance with various aspects described herein. This circuitry 700 may correspond to the communication circuitry described in accordance with FIG. 5. Illustratively, the first DTC 501 may include digitally controlled edge interpolator (DCEI) 0 711 and the second DTC 502 may include DCEI 1 721. The first DPA 511 may include DPA core 0 731 and the second DPA 512 may include DPA Core 1 741. The PLL 520 may provide 4xLO signals to the circuitry 700. The power combiner 520 may include the transformer 790. The used term 4xLO may refer to the signal that is at 4 times frequency of the signals clocking DTC and/or DPA.

The circuitry 700 may receive oversampled (e.g. 4xLO) oscillator signals, which may provide a clocking source. The oversampled oscillator signals may be routed to a multi-modulus divider (MMD) 760, which may divide the incoming signal with a corresponding amount (e.g. by 4 in 4xLO example) and distribute phase-clock signals I and Q (i.e. I₀, Q₀ for the first signal path and I₁, Q₁ for the second signal path) to subsequent components, including the digitally controlled edge interpolators (DCEI 0 711 and DCEI 1 721).

A parallel-to-serial synchronization block (Sync-P2S) 701 may output DTC codes (i.e. the phase modulation command codes) and DPA (i.e. the amplitude modulation command codes). A DTC decoder 712 of DCEI 0 711 may receive these DTC codes (Czc_0 (e.g. 13 bits) and share the received DTC codes with the MMD 760 (3 bits) and the DCEI 0 (11 bits). DCEI 0 711 may adjust the timing of the received oscillator signal I₀, Q₀ based on the code received from its DTC decoder 712. DCEI 0 711 may accordingly output the first modulated oscillator signal MOLO0. This signal may propagate to DPA Core 0 731. A DPA decoder 732 of corresponding DPA Core 0 731 may receive the DPA codes (Cam _0) provided by Sync-P2S and the DPA Core 0 731 may amplify the first modulated oscillator signal MOLO0 to provide amplified signal to the transformer 790..

DCEI 1 721's and DPA Core 1 741 operations are similar to DCEI 0 711 and DPA Core 0 731, but they operate with a delay that may be a fractional delay as described herein. To facilitate an operation with a designated delay between the two signal paths, in which the first signal path including DCEI 0 711 and the second signal path including DCEI 1 721, the circuitry may include a delay circuit clocked by the oversampled oscillator signals. Illustratively, the delay circuit, in the first embodiment, may include shift registers 750, 760, 770 clocked by the oversampled oscillator signals.

A first shift register 750 may be MMD IQ shift register 750 to introduce a fractional delay to the oscillator signal received by DCEI 1 721, converting I₀ and Q₀ signals, which are also received by DCEI 0 711, into their delayed versions I₁ and Q₁ respectively. A second shift register 760 may be DTC code modulation shift register 760 to introduce a fractional delay to the phase modulation command codes received by DCEI 1 721, converting Czc_0 signal, which is also received by DCEI 0 711, into its delayed version Czc_1. A third shift register 770 may be DPA code modulation shift register 770 to introduce a fractional delay to the amplitude modulation command codes received by DPA Core 1 741, converting Cam_0 signal, which is also received by DPA core 0 731, into its delayed version Cam_1. Illustratively, the fractional delays introduced by these shift registers are equal for a synchronized operation at two signal paths with a time difference.

Correspondingly, in the first embodiment, the first DTC may include DCEI 0 711, which may receive the phase modulation command signal Czc_0 from the DTC decoder 712. DCEI 0 711 may also receive oscillator signals I₀, Q₀ provided by the MMD 760. DCEI 0 711 may process these inputs to modulate the timing of the oscillator signals in accordance with the received phase modulation command signal. The output of DCEI 0 711, referred to as the first modulated local oscillator signal MOLO_0, may be transmitted to the first digital power amplifier DPA Core 0 731. In an example, DCEI 0 711 may further include programmable delay components internally to align the oscillator signal with the received phase modulation command.

Similarly, the second DTC may include DCEI 1 721, which may operate similarly to DCEI 0 711 but processes a delayed version of the phase modulation command signal Czc_1. The programmable delay may be introduced by the delay circuit, which may include shift registers such as DTC code modulation shift register 760. DCEI 1 721 may receive oscillator signals I₁, Q₁, which are delayed versions of the signals I₀, Q₀ received by DCEI 0 711. The delayed oscillator signals may be generated by the MMD IQ shift register 750. DCEI 1 721 may output the second modulated local oscillator signal MOLO_1, which may be transmitted to the second digital power amplifier DPA Core 1 741. For example, to implement the programmable delay, DTC code modulation shift register 760 may be clocked by the oversampled oscillator signal to achieve precise timing adjustments.

In an example, the circuitry may include a phase inverter configured to invert the phase of one of the first or second output signals (e.g. the first modulated local oscillator signal or the second modulated local oscillator signal). This phase inversion functionality may be implemented within the signal path of the second output signal. Specifically, an XNOR gate may be used within DPA Core 1 741 to selectively invert the phase of the second modulated local oscillator signal MOLO_1. The XNOR gate may receive a control signal, which may indicate whether the phase inversion is enabled. This control signal may correspond to the operational mode of the circuitry, such as fractional delay mode. The phase-inverted signal may then be amplified by DPA Core 1 741. Illustratively, the control signal may instruct the phase inverter to invert the phase when the circuitry is configured to operate with a fractional delay. The control signal may further instruct the phase inverter to not to apply the phase inversion when the circuitry is configured to operate without a delay and/or with an integer delay.

In an example, DCEI 0 711 may generate the first modulated local oscillator signal by sampling with a sampling frequency, and the programmable delay applied by the delay circuit may correspond to a fraction of the sampling period associated with this frequency in a fractional delay configuration. The sampling frequency may be derived from the oversampled oscillator signals. The delay circuit, including the shift registers 750, 760, 770, may facilitate fractional delays by introducing timing offsets to the phase modulation and amplitude modulation command signals, as well as to the oscillator signals. For example, the sampling frequency may be four times the oscillator frequency to allow fine-grained delay adjustments.

In an example, the second output signal may be a shifted version of the first output signal, representing the first output signal shifted in time by a fractional number of samples. This shifting operation may be performed by the delay circuit, which includes the shift registers 750, 760, 770. With respect to signals received by DCEI 1 721 and DPA Core 1 741, the MMD IQ shift register 750 may delay the oscillator signals, the DTC code modulation shift register 760 may delay the phase modulation command signal, and the DPA code modulation shift register 770 may delay the amplitude modulation command signal. These synchronized delays may cause that the second output signal is aligned with the designated fractional delay. Illustratively, the provided fractional delay may correspond to a specific configuration of the shift register, and the shift register may be configured to facilitate multiple fractional delays (e.g. multiple delay amounts).

Accordingly, DCEI 1 721 may generate the second output signal by sampling a delayed version of the phase modulation command signal. This may be facilitated by the DTC code modulation shift register 760, which delays the phase modulation command signal Czc_0 to produce the delayed version Czc_1 received by DCEI 1 721. In an example, the programmable delay may be configurable to a plurality of fractional values. The delay circuit, including the shift registers 750, 760, 770, may introduce delays corresponding to fractional values such as ¼, ½, and ¾ of the sampling period. These fractional values may be configured based on the operational requirements of the circuitry. Illustratively, a controller provides the control signal according to desired Tx-FIR filter response based on radio communication operations.

In an example, one or more input terminals may receive the oscillator signal and the phase modulation command signal, and an output terminal may provide the respective output signal. This configuration may be implemented in both DCEI 0 711 and DCEI 1 721 and/or both DPA Core 0 731 and DPA Core 1 741. The signal path may include an XNOR gate, which may include a first gate input terminal coupled to the input terminal, a second gate input terminal may be configured to receive the control signal representing whether to invert the phase, and a gate output terminal coupled to the output terminal. Correspondingly switching between the fractional delay configuration and non-delay or integer delay configuration may be facilitated in a simple manner.

For example, in a case, DPA Core 0 731 is coupled to the DCEI 0 711 and DPA Core 1 741 is coupled to the DCEI 1 721, each may be configured to amplify the respectively received modulated oscillator signal and received amplitude modulation command signal (delayed or not).In the illustrative example that the second signal path being the delayed signal path, the delayed amplitude modulation command signal Cam_1 may be generated by the DPA code modulation shift register 770.

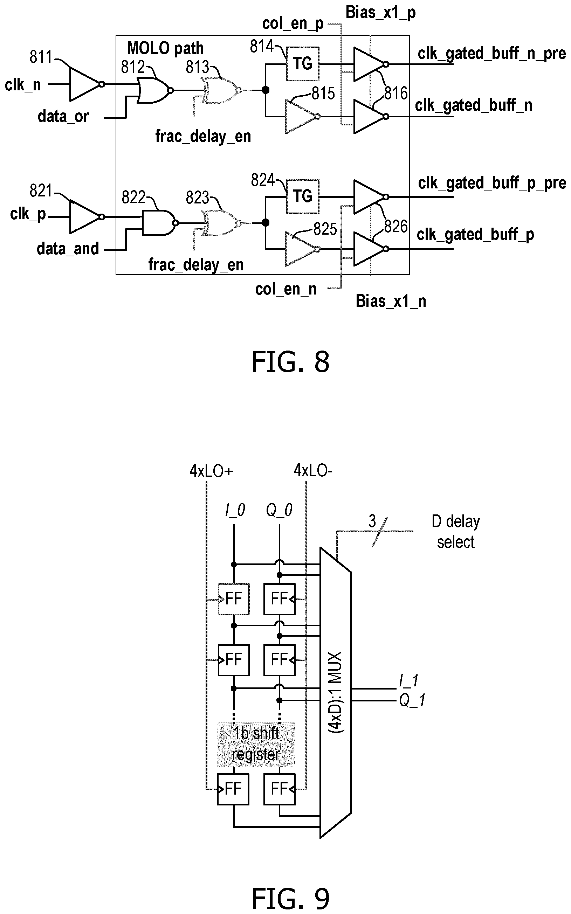

FIG. 8 illustrates a circuit diagram of a DPA cell within a DPA amplifier, such as DPA Core 1 741, in a digital polar transmission architecture. The depicted DPA cell may receive modulated local oscillator signals (e.g. MOLO_1) and based on amplitude modulation command signals, enable the activation and deactivation of the cell. The circuit may include two main signal paths, each associated with one of the complementary clock signals, clk_n and clk_p. These signals may represent the received modulated local oscillator signals, such as those generated by DCEI 1 721. The first signal path may begin with clk_n received at inverter 811, while the second path begins with clk_p received at inverter 821.

For the first path, clk_n is processed alongside a data_or signal at a logic gate 812. The data_or signal is based on the amplitude modulation command signal received by the DPA amplifier, which indicates whether the cell should be activated or deactivated based on the received command. The output of the logic gate 812 may be provided to the phase inverter 813, which may selectively invert the phase of the signal depending on the state of the control signal frac_delay_en. This control signal may enable to facilitate fractional delay configurations when asserted. For example, frac_delay_en may be activated during fractional delay operations, allowing the phase inversion to correct any signal distortion caused by the delay.

The output of phase inverter 813 is further processed through a transmission gate (TG) 814 and inverter 815, which may provide additional signal isolation and routing functionality. Outputs of transmission gate 814 and inverter 815 may be provided to respective gated buffers 816. These buffers may output the signal at a desired signal level that is associated with col_en_p and Bias_x1_p, which manage power delivery and cell biasing.

The second signal path may operate similarly (or in the same manner) to the first signal path described herein with the exception of different input and output signals depicted in FIG. 8.

Both signal paths may operate in a complementary manner. The phase inversion functionality, supported by XNOR gates as phase inverters 813 and 823, may facilitate that the signal integrity is preserved when fractional timing offsets are introduced to minimize distortion and maintain desired filtering characteristics. The col_en_p and col_en_n signals may provide enabling control for the respective paths, while Bias_x1_p and Bias_x1_n may manage the biasing of the gated buffers. These components may collectively ensure efficient operation of the DPA cell. For completion, the corresponding DPA may include multiple DPA cells identical to the DPA cell described herein. Signals received from the DPA decoder, which is based on the received amplitude modulation command signal, may activate or deactivate each DPA cell according to the received amplitude modulation command signal to obtain the desired signal level at the output of the DPA, which may be the combination of outputs of each DPA cell.

In an example, DPA Cores 731, 741 each may have an input terminal configured to receive the respective modulated oscillator signal from the corresponding coupled DCEI 711, 721. In this constellation, the input terminals of the DPA cell may receive modulated oscillator signal, such as clk_n and clk_p for the first and second paths respectively. Additionally, data_or and data_and may represent the amplitude modulation command signals for each respective path. The signal path within the DPA cell, may include an XNOR gate, to invert the phase the phase inverters 813 and 823. Each XNOR gate 813, 823 may include a first gate input terminal coupled to the input terminal for receiving the respective oscillator signal (e.g., clk_n or clk_p) and a second gate input terminal configured to receive a control signal, such as frac_delay_en, which may indicate whether phase inversion is applied. The gate output terminal of the XNOR gate may be coupled to the output terminal, providing the processed signal. For example, when the frac_delay_en signal indicates a fractional delay configuration, the XNOR gate may invert the phase of the signal to correct distortion caused by fractional timing offsets. Conversely, when the frac_delay_en signal indicates an integer delay or no delay configuration, the XNOR gate may bypass the phase inversion to maintain the signal's integrity.

In an example, the circuitry may include a controller (not shown) configured to adjust the programmable delay provided by the delay circuit. This controller may interface with the shift registers 750, 760, 770 to configure the fractional delay values based on the operational requirements. In some examples, the controller may receive feedback from the output of the Tx-FIR filter to refine the delay settings dynamically.

As described herein, the programmable delay may be implemented to generate filtered signals as a Tx-FIR filter. The programmable delays introduced by the shift registers may enable the timing offsets required for Tx-FIR filtering. The transformer 790 may combine outputs of the DPA Cores 731, 741 to obtain the output of the Tx-FIR filter.

FIG. 9 illustrates a schematic example of an MMD IQ shift register (e.g. th MMD IQ shift register 750) of a delay circuit. The shift register may facilitate the introduction of a programmable fractional delay to a received oscillator signal. The shift register may handle oscillator signals, specifically I₀ and Q₀ signals described in accordance with FIG. 7, and delay them to generate I₁ and Q₁ signals for synchronization with the fractional delay configuration.

The shift register circuit may include flip-flops (FFs) arranged in a sequential configuration along each signal path. The incoming oversampled oscillator signals (oversampled compared to clock signals of the DTC and DPA (i.e. I₀ and Q₀)), 4xLO+ and 4xLO-, may be routed to the I₀ and Q₀ paths. Each flip-flop along these paths may be clocked by the 4xLO signals. A control signal, D delay select 3, may configure the fractional delay by determining the selection of specific outputs from the shift register. The outputs of the flip-flops may be routed to a (4xD): 1 multiplexer (MUX), which may combine the delayed signals. The MUX may receive control input D delay select 3 to determine the selection of one of the delayed signals from the flip-flop outputs. The selected outputs, I₁ and Q₁, represent the delayed versions of the input signals, I₀ and Q₀, with a fractional timing offset introduced by the shift register. For example, the shift register may be a 1-bit shift register to ensure compatibility with non-integer delay configurations. This may allow the MMD IQ shift register to support fractional delay configurations, such as ¼, ½, and ¾ of the oscillator signal period, by adjusting the timing of the output signals accordingly.

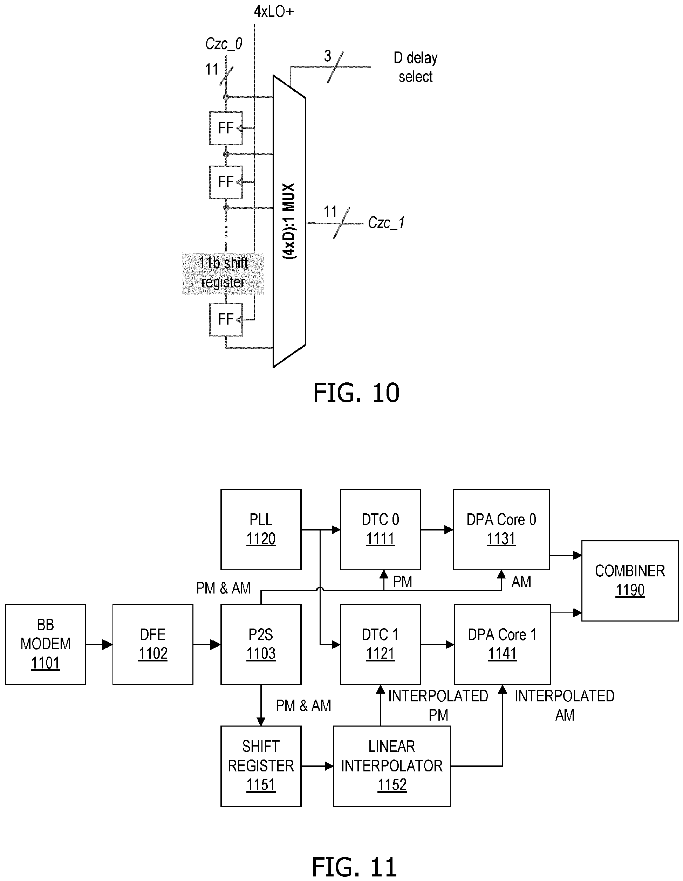

FIG. 10 illustrates a schematic of an example shift register circuit configured to facilitate programmable delays within a digital polar transmission architecture. The depicted circuit may correspond to the DTC code modulation shift register 760 or the DPA code modulation shift register 770. For the purpose of this example, it is assumed to be the DTC code modulation shift register 760. This shift register may enable fractional or integer delays in phase modulation command signals to ensure synchronization and precise timing adjustments for downstream components.

The circuit include may include a series of FFs clocked by the oversampled oscillator signal 4xLO+. The input signal to the circuit, Czc_0, represents the received phase modulation command signal. As the signal propagates through the flip-flops, incremental delays may be introduced. These delays may be determined by the configuration of a delay selection control signal, D delay select 3. The delayed outputs of the flip-flops may be routed to a (4xD): 1 multiplexer (MUX), which may select one of the delayed signals based on the D delay select 3 input. The MUX output, Czc_1, may represent the delayed version of the input phase modulation command signal, synchronized with the designated delay configuration.

Referring back to FIG. 5, in the second embodiment, the circuitry may facilitate the generation of a fractional delay by a linear interpolator. Illustratively, the delay circuit that may provide programmable delay may include a linear interpolator, for example, to process phase modulation command signals.

In an example, the first DTC 501 may generate the first output signal by sampling the phase modulation command signal. In certain applications, the digital front end may provide the phase modulation and the amplitude modulation command signals with smaller sampling periods than the sampling periods required to process the oscillator signals provided to the circuitry. Through the oversampled nature of the phase modulation and amplitude modulation command signals, employing linear interpolation to introduce delays may result in negligible distortion (e.g. smaller than 70dBc).

Illustratively, the first DTC 501 may receive the phase modulation command signal, illustratively provided by the digital front end or processing circuitry, and adjust the timing of the oscillator signal generated by the PLL 520 to produce a first time-modulated signal (i.e. the first output signal, the first modulated local oscillator signal). This first output signal may propagate along the first signal path and may serve as a reference for subsequent delays introduced in the second signal path.

In this example, the circuitry may include a delay circuit including a linear interpolator. The linear interpolator may be configured to introduce a fractional delay relative to the phase modulation command signal to obtain an interpolated phase modulation command signal. The delay circuit may be implemented as part of the second signal path, incorporating the linear interpolator and, optionally, a shift register. The linear interpolator may calculate the interpolated phase modulation command signal by applying a weighted sum of adjacent samples of the input signal. In an example, the linear interpolator may be activated with a control signal or in a fractional delay configuration.

In an example, the second DTC 502 may generate the second output signal based on the interpolated phase modulation command signal. The second DTC 502 may receive the interpolated signal, adjust the timing of the oscillator signal provided by the PLL 520 accordingly, and produce the second output signal. This signal may propagate along the second signal path and exhibit a fractional delay relative to the first output signal. The linear interpolator may generate the interpolated phase modulation command signal based on the phase modulation command signal and provide the interpolated phase modulation command signal to the second DTC 502. Correspondingly, the second DTC 502 may translate the interpolated phase modulation command signal into a time-modulated second output signal (i.e. the second output signal, the second modulated local oscillator signal).

The interaction of the fractional delay with other features may include synchronized amplification of the first and second output signals. In the second embodiment, the first amplifier circuit, such as DPA 511, may amplify the first output signal based on the amplitude modulation command signal, while the second amplifier circuit, such as DPA 512, may amplify the second output signal based on an interpolated amplitude modulation command signal, generated by applying a similar delay mechanism as described for the phase modulation command signals.

In accordance with the second embodiment, the fractional delay introduced by the linear interpolator may be configurable with multiple fractional values, such as ¼, ½, or ¾ of the sampling period as illustratively described for the first embodiment, but the linear interpolator, with its interpolation function, may provide more granular fractional values, such as with steps of 0,05, 0,1, 0,15, 0,20 fractions. These values may be selected based on the requirements of the Tx-FIR filter configuration, illustratively to achieve specific notch frequencies for the frequency response. The delay circuit may combine the fractional delay from the linear interpolator with an integer delay from the optional shift register to generate the interpolated signal. This combined delay mechanism may facilitate a compatibility with broader system requirements while maintaining precise timing control. The programmable nature of the delay circuit may facilitate dynamic adjustments based on the desired transmission characteristics and Tx-FIR filter response.

The embodiment may also include additional features to enhance its functionality. For instance, a phase unwrapper may be included upstream of the linear interpolator to process the phase modulation command signal and ensure continuity in the phase representation. This phase unwrapping operation may address discontinuities caused by phase wrapping and provide a clean input signal to the interpolator. Furthermore, a controller may be coupled to the delay circuit and linear interpolator to configure the delay parameters based on the desired transmission characteristics or filtering requirements.

FIG. 11 shows an exemplary illustration of an RF transceiver including a circuitry as described herein. The circuitry may be the circuitry of the second embodiment. The circuitry may be configured to implement a Tx-FIR filtering operation. In an example, the Tx-FIR filtering operation may be provided by signals received from a single digital front end (DFE). Aspects described for the second embodiment may overcome the need for additional DFEs for providing delayed phase modulation and amplitude modulation command codes. The RF transceiver (e.g. the RF transceiver 320) may include a baseband modem (BB modem) 1101, a digital front end (DFE) 1102, a parallel-to-serial converter (P2S) 1103, digital-to-time converters (DTCs) 1111 and 1121, digital power amplifiers (DPAs) 1131 and 1141, a phase-locked loop (PLL) 1120, a combiner 1190, and delay circuit elements such as a shift register 1151 and a linear interpolator 1152.

The baseband modem 1101 may output baseband signals to the digital front end 1102, which may generate phase modulation (PM) and amplitude modulation (AM) command signals based on the input baseband signals, which may originate from higher-layer communication protocols. These signals may represent the digital representation of the desired RF output and include the necessary phase and amplitude information to modulate an oscillator signal. The baseband modem 1101 may interface with the digital front end 1102, which may preprocess these signals to meet the requirements of downstream components. This preprocessing may include oversampling to ensure a sufficiently high sampling rate, facilitating precise timing adjustments during the interpolation process.

The digital front end 1102 may output PM and AM command signals, which may be passed to the parallel-to-serial converter 1103. The parallel-to-serial converter 1103 may split these signals into two paths, eventually to send them to the first DTC 1111 and the second DTC 1121. The first DTC 1111 may receive the PM and AM command signals output by the parallel-to-serial converter 1103. The delay circuit including the shift register 1151 and the linear interpolator 1152 may also receive the PM and AM command signals output. This bifurcation may enable the RF transceiver to create two separate streams of the same signal, which may be used for implementing the Tx-FIR filter effect.

The first signal path includes the first DTC 1111, which may receive the PM and AM signals directly from the parallel-to-serial converter 1103. The first DTC 1111 may process the PM signal to adjust the timing of the oscillator signal provided by the PLL 1120, thereby generating a first time-modulated output signal. This process may involve sampling the PM command signal and aligning it with the oscillator signal to produce a signal suitable for RF transmission. The first DTC 1111 may output this modulated signal to the first DPA 1131, which is configured to amplify it based on the AM command signal. The first DPA 1131, through its amplification process, may ensure the output RF signal has the desired power level corresponding to the AM command signal. The amplified signal from the first DPA 1131 may be then sent to the combiner 1190.

As depicted herein, the second signal path may incorporate the delay circuit, which may include the shift register 1151 and the linear interpolator 1152, to generate delayed versions of the PM and AM command signals. In an example, the shift register 1151 may introduce the integer component of the required delay by passing the PM and AM signals through a sequence of flip-flops. Each flip-flop in the shift register 1151 may correspond to one clock cycle of delay, allowing the system to achieve coarse timing adjustments in terms of whole sampling periods. The shift register outputs may then be provided to the linear interpolator 1152, which may calculate the fractional component of the delay. The linear interpolator 1152 may apply a weighted sum of adjacent signal samples to achieve sub-sample timing offsets, to introduce fractional delays relative to the original signals.

For example, if a delay of 6.2 sampling periods is required, the shift register 1151 may provide an integer delay of 6 periods, while the linear interpolator 1152 introduces an additional fractional delay of 0.2 periods. The operation of the linear interpolator 1152 may be controlled by a dedicated control signal, allowing the system to dynamically adjust the fractional delay based on operational requirements. The interpolated PM and AM signals generated by the delay circuit may then be sent to the second DTC 1121 and the second DPA 1141.

The second DTC 1121 may receive the interpolated PM signal and use it to adjust the timing of the oscillator signal provided by the PLL 1120. Similar to the first DTC 1111, the second DTC 1121 may sample the interpolated PM signal and align it with the oscillator signal to produce a time-modulated output signal. However, due to the fractional delay introduced in the second path, the timing of the second output signal differs from that of the first output signal. The second DTC 1121 outputs the time-modulated signal to the second DPA 1141.

The second DPA 1141 may amplify the second output signal based on the interpolated AM signal received from the delay circuit. This amplification process may ensure that the second output signal is adjusted to the desired power level, consistent with the amplitude information in the interpolated AM command signal. The amplified signal from the second DPA 1141 may then be sent to the combiner 1190. The combiner 1190 may receive the amplified signals from both DPAs 1131 and 1141 and merge them to produce a composite RF output signal. The timing difference between the two paths, introduced by the delay circuit, may create a FIR filtering effect.

The PLL 1120 plays a central role in the circuitry by generating the oscillator signal used as a timing reference for both DTCs 1111 and 1121. This oscillator signal may facilitate synchronized operation across the two paths, allowing the Tx-FIR filter effect to be implemented. The shift register 1151 and linear interpolator 1152 collectively form the delay circuit, which is essential for achieving the required fractional delay. The shift register's integer delay capability allows the system to make coarse timing adjustments, while the linear interpolator's fractional delay capability provides fine-grained control. Together, these components enable the system to achieve precise timing offsets, necessary for implementing the Tx-FIR filtering operation with high resolution.

In certain configurations, a phase unwrapper (not shown) may be included upstream of the linear interpolator 1152 to ensure continuity in the phase modulation command signal. This phase unwrapper may address phase discontinuities caused by wrapping and provide a smooth input signal for interpolation. Additionally, a controller may be integrated to manage the delay circuit and linear interpolator, dynamically adjusting the delay parameters based on the desired transmission characteristics or filtering requirements.

In an example, the fractional delay introduced by the linear interpolator 1152 may include a fractional portion of a sampling period of the phase modulation command signal. The linear interpolator 1152 may calculate the interpolated phase modulation command signal using the signal received from the shift register 1151. The fractional portion may be configured dynamically to align with the desired delay requirements for the Tx-FIR operation. For instance, the fractional delay may correspond to a fraction such as 0,05, 0,10, 0,15, 0,20, ¼, ½, or ¾ of the sampling period.

In an example, the delay circuit may further include the shift register 1151 to generate an integer delay component for the phase modulation command signal. The shift register 1151 may include multiple flip-flops arranged in series, in which each flip-flop may introduce a delay equivalent to one clock cycle. The integer delay component provided by the shift register may serve as a coarse timing adjustment, to allow the delay circuit to produce a baseline delay before applying the fractional portion via the linear interpolator 1152. For example, for a required total delay of 5.3 sampling periods, the shift register may introduce an integer delay of 5 sampling periods. In an example, the delay circuit may include a delay line to introduce an integer delay component.

In an example, the delay circuit may combine the integer delay component of the shift register and the fractional delay component of the linear interpolator 1152 to produce the interpolated phase modulation command signal. Illustratively, the shift register 1151 may first delay the phase modulation command signal by the required integer number of sampling periods, after which the linear interpolator 1152 may compute the interpolated signal by applying the fractional delay component. This combined operation may result in a desired timing offset for the signal propagating through the second path. For example, if the delay required is 6.7 sampling periods, the shift register may delay the signal by 6 periods, while the linear interpolator 1152 introduces an additional 0.7-period delay.

In an example, the linear interpolator 1152 may calculate the interpolated phase modulation command signal using a weighted sum of adjacent samples of the phase modulation command signal. The weights applied to the adjacent samples may correspond to the fractional delay required. For instance, if the fractional delay is 0.25 periods, the linear interpolator 1152 may compute the interpolated value as *A*[*n*-k]·0.75+ *A*[*n*-(*k*+1)]·0.25, where A[n-k] and A[n-(k+1)] represent the adjacent samples. This weighted interpolation ensures that the output signal aligns with the desired timing offset. The amount k may define the amount of the fractional delay introduced by the linear interpolator 1152.

In an example, the phase modulation command signal received by the delay circuit may include a phase modulation command signal generated at a sampling rate greater than twice the bandwidth of a baseband signal generated by a baseband processor. The oversampling may ensure sufficient temporal resolution for the linear interpolator 1152 to calculate corresponding fractional delays. The baseband signal generated by the baseband modem 1101 may represent the desired RF signal characteristics, while the digital front end 1102 may process and generate the phase modulation command signal.

In an example, the first DTC 1111 and the second DTC 1121 may generate the first output signal and the second output signal, respectively, with a delay between the first output signal and the second output signal. This delay may include the fractional delay introduced by the linear interpolator 1152. The first DTC 1111 may process the phase modulation command signal directly from the parallel-to-serial converter 1103, while the second DTC 1121 processes the interpolated phase modulation command signal.

In an example, the first amplifier circuit, such as DPA 1131, may amplify the first output signal based on the amplitude modulation command signal, while the second amplifier circuit, such as DPA 1141, may amplify the second output signal based on the interpolated amplitude modulation command signal. The interpolation of the amplitude modulation command signal may be performed by the same delay circuit, including the shift register 1151 and the linear interpolator 1152, that processes the phase modulation command signal.

In an example, the delay circuit may generate a delayed version of the amplitude modulation command signal, where a first time offset between the phase modulation command signal and the interpolated phase modulation command signal corresponds to a second time offset between the amplitude modulation command signal and the interpolated amplitude modulation command signal. This synchronization between the phase and amplitude modulation delays may facilitate consistent timing alignment across the two signal paths, which is critical for maintaining the desired frequency response of the Tx-FIR filter.

In an example, the linear interpolator may introduce the fractional delay relative to the amplitude modulation command signal to obtain the interpolated amplitude modulation command signal. The interpolation process for the amplitude modulation command signal may operate similarly to that of the phase modulation command signal, applying a weighted sum of adjacent samples to achieve the required fractional delay.

In an example, the circuitry may further include a phase unwrapper coupled to the input of the linear interpolator. The phase unwrapper may process the phase modulation command signal to ensure continuity in its representation before interpolation. For instance, if the phase modulation command signal experiences discontinuities due to phase wrapping, the phase unwrapper may resolve these discontinuities, providing a smooth signal for the linear interpolator 1152 to process.

In an example, the programmable delay introduced by the delay circuit, including the linear interpolator 1152 and the shift register 1151, may be implemented to generate filtered signals in a Tx-FIR filter. The delay applied to the second signal path relative to the first path creates the necessary timing offsets for implementing the FIR filtering effect. This filtering may be used to suppress out-of-band noise and achieve precise frequency response configurations. In an example, the circuitry may further include a combiner configured to combine the outputs of the first amplifier circuit and the second amplifier circuit to generate the filtered signals. The combiner 1190 may receive the amplified signals from both DPAs 1131 and 1141 and merge them into a single composite signal. The timing difference between the two paths creates constructive and destructive interference at specific frequencies, resulting in the desired FIR filtering effect.

In an example, the circuitry may further include a controller configured to control the linear interpolator 1152 based on a Tx-FIR response configured for a transmission. The controller may dynamically adjust the delay parameters of the linear interpolator and shift register to achieve the desired notch frequencies or other frequency response characteristics. This dynamic control ensures that the system can adapt to varying transmission requirements and operational conditions.

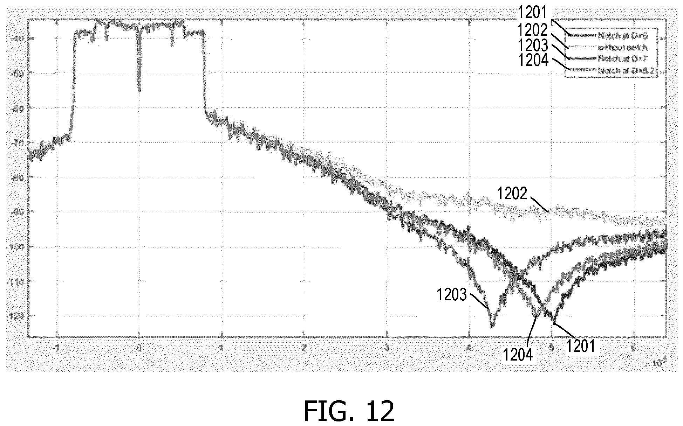

FIG. 12 illustrates an example graph of the magnitude response versus frequency for a system configured to implement integer and fractional delays (e.g. the second embodiment), demonstrating the generation of notch frequencies using the described Tx-FIR filtering operation. The x-axis represents the frequency in normalized units, while the y-axis represents the magnitude response in decibels (dB). The depicted curves correspond to different delay configurations, including integer delays and a fractional delay achieved using linear interpolation.

Line 1202 represents the magnitude response without a notch, providing a baseline for comparison. This response corresponds to a configuration where no delays are applied between the two signal paths in the Tx-FIR implementation. Line 1203 shows the magnitude response for a notch at an integer delay of D=6. This integer delay creates a distinct attenuation notch at the frequency Fs/12, where *Fs* is the sampling rate of the phase modulation and amplitude modulation command signals.

Line 1204 demonstrates the effect of a fractional delay of D=6.2. This fractional delay may be achieved by combining an integer delay of D=6 with a fractional delay of 0.2, implemented using a linear interpolator. The notch frequency observed for this configuration lies between the notches produced by integer delays D=6 and D=7, to enable finer control over the filtering operation. The resulting response demonstrates how fractional delays improve the resolution of the Tx-FIR filter by enabling notches at non-integer frequency offsets.

Line 1201 depicts the magnitude response for a notch at D=7, corresponding to an integer delay. Aspects described herein may achieve these notches by introducing programmable delays between the first and second signal paths, using components such as a shift register for integer delays and a linear interpolator for fractional delays. The delay circuit may output delayed versions of the phase modulation and amplitude modulation command signals, which are processed by the second digital-to-time converter to produce the second modulated local oscillator signal. This delayed signal, when combined with the first signal, produces the Tx-FIR filtering effect observed in the graph.

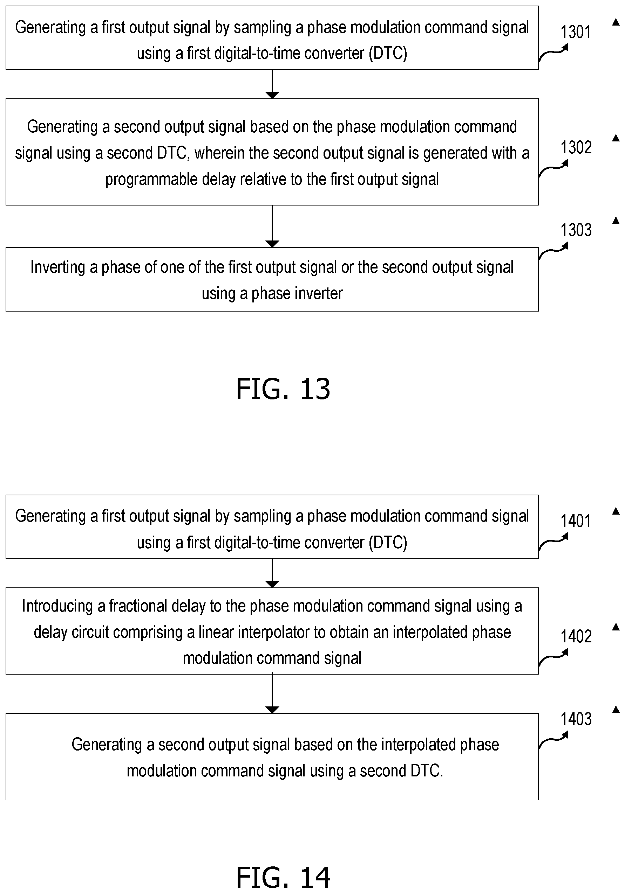

FIG. 13 shows an example of a method. The method may include: generating 1301 a first output signal by sampling a phase modulation command signal using a first digital-to-time converter (DTC); generating 1302 a second output signal based on the phase modulation command signal using a second DTC, wherein the second output signal is generated with a programmable delay relative to the first output signal; and inverting 1303 a phase of one of the first output signal or the second output signal using a phase inverter. A computer-readable medium may store instructions which, if executed, cause a processor to perform the method.

FIG. 14 shows an example of a method. The method may include: generating 1401 a first output signal by sampling a phase modulation command signal using a first digital-to-time converter (DTC); introducing 1402 a fractional delay to the phase modulation command signal using a delay circuit including a linear interpolator to obtain an interpolated phase modulation command signal; and generating 1403 a second output signal based on the interpolated phase modulation command signal using a second DTC. A computer-readable medium may store instructions which, if executed, cause a processor to perform the method.

The following examples pertain to further aspects described herein.

Example 1 includes the subject matter of a circuitry that may include: a first digital-to-time converter, DTC, configured to generate a first output signal by sampling a phase modulation command signal; a second DTC configured to generate a second output signal based on the phase modulation command signal with a programmable delay relative to the first output signal; and a phase inverter configured to invert a phase of one of the first output signal or the second output signal.

Example 2 may include the subject matter of example 1, wherein the first DTC is configured to generate the first output signal by sampling with a sampling frequency; and wherein an amount of the programmable delay is a fraction of a sampling period corresponding to the sampling frequency.

Example 3 may include the subject matter of example 1 or example 2, wherein the second output signal is a shifted first output signal representing the first output signal that has been shifted in time with a fractional number of samples.

Example 4 may include the subject matter of any one of examples 1 to 3, wherein the second DTC is configured to generate the second output signal by sampling a delayed version of the phase modulation command signal.

Example 5 may include the subject matter of any one of examples 1 to 4, wherein the programmable delay is configurable to a plurality of fractional values.

Example 6 may include the subject matter of any one of examples 1 to 5, further may include a controller configured to adjust the programmable delay.

Example 7 may include the subject matter of any one of examples 1 to 6, further may include a delay circuit coupled to the second DTC; and wherein the delay circuit is configured to apply the programmable delay based on a received oversampled oscillator signal to the phase modulation command signal.

Example 8 may include the subject matter of example 7, wherein the delay circuit includes a shift register.

Example 9 may include the subject matter of any one of examples 1 to 8, further may include: a first amplifier circuit coupled to the first DTC and configured to amplify the first output signal based on an amplitude modulation command signal; and a second amplifier circuit coupled to the second DTC and configured to amplify the second output signal based on a delayed version of the amplitude modulation command signal.

Example 10 may include the subject matter of example 9, wherein the first amplifier circuit or the second amplifier circuit includes: an input terminal configured to receive the first output signal and the amplitude modulation command signal; an output terminal coupled to the input terminal via a signal path to provide a respective first amplified output signal or a second amplified output signal; wherein the signal path includes an XNOR gate may include: a first gate input terminal coupled to the input terminal; a second gate input terminal configured to receive a control signal representing whether to invert the phase of the first output signal or the second output signal; and a gate output terminal coupled to the output terminal.

Example 11 may include the subject matter of example 10, wherein the control signal is representative of a state of at least one of: an enablement of a fractional delay configuration; and/or a disablement of the fractional delay configuration for an integer delay configuration.

Example 12 may include the subject matter of any one of examples 9 to 11, further may include an amplifier delay circuit coupled to the second amplifier circuit; wherein the amplifier delay circuit is configured to apply the programmable delay based on a received oversampled oscillator signal to the amplifier modulation command signal.

Example 13 may include the subject matter of example 12, wherein the amplifier delay circuit includes a further shift register.

Example 14 may include the subject matter of any one of examples 1 to 13, wherein the programmable delay is implemented to generate filtered signals in a transmitter finite impulse response, Tx-FIR, filter.

Example 15 may include the subject matter of example 14, further includes a combiner configured to combine outputs of the first amplifier circuit and the second amplifier circuit to generate the filtered signals.

Example 16 may include the subject matter of a circuitry that may include: a first digital-to-time converter, DTC, configured to generate a first output signal by sampling a phase modulation command signal; a delay circuit may include a linear interpolator configured to introduce a fractional delay relative to the phase modulation command signal to obtain an interpolated phase modulation command signal; and a second DTC configured to generate a second output signal based on the interpolated phase modulation command signal.

Example 17 may include the subject matter of example 16, wherein the fractional delay introduced by the linear interpolator includes a fractional portion of a sampling period of the phase modulation command signal.

Example 18 may include the subject matter of example 16 or 17, wherein the delay circuit further includes a shift register configured to generate an integer delay component for the phase modulation command signal.

Example 19 may include the subject matter of example 18, wherein the delay circuit combines the integer delay component of the shift register and a fractional delay component of the linear interpolator corresponding to the fractional delay to produce the interpolated phase modulation command signal.

Example 20 may include the subject matter of any one of examples 16 to 19, wherein the linear interpolator is configured to calculate the interpolated phase modulation command signal using a weighted sum of adjacent samples of the phase modulation command signal.

Example 21 may include the subject matter of any one of examples 16 to 20, wherein the phase modulation command signal received by the delay circuit includes an oversampled phase modulation command signal generated at a sampling rate greater than twice a bandwidth of a baseband signal generated by a baseband processor, wherein the phase modulation command signal is generated based on the baseband signal.

Example 22 may include the subject matter of any one of examples 16 to 21, wherein the first DTC and the second DTC are configured to generate the first output signal and the second output signal respectively with a delay between the first output signal and the second output signal, wherein the delay includes the fractional delay.

Example 23 may include the subject matter of any one of examples 16 to 22, further may include: a first amplifier circuit coupled to the first DTC and configured to amplify the first output signal based on an amplitude modulation command signal; and a second amplifier circuit coupled to the second DTC and configured to amplify the second output signal based on an interpolated amplitude modulation command signal.

Example 24 may include the subject matter of example 23, wherein the delay circuit is configured to generate the delayed version of the amplitude modulation command signal; wherein a first time offset between the phase modulation command signal and the interpolated phase modulation command signal corresponds to a second time offset between the amplitude modulation command signal the interpolated amplitude modulation command signal.

Example 25 may include the subject matter of example 23 or example 24, wherein the linear interpolator is configured to introduce the fractional delay relative to the amplitude modulation command signal to obtain the interpolated amplitude modulation command signal.

Example 26 may include the subject matter of any one of examples 16 to 25, further may include a phase unwrapper coupled to the input of the linear interpolator, wherein the phase unwrapper is configured to unwrap a phase of at least one of a received phase modulation command signal and provide phase unwrapped signal to the input of the linear interpolator.

Example 27 may include the subject matter of any one of examples 16 to 26, wherein the programmable delay is implemented to generate filtered signals in a transmitter finite impulse response, Tx-FIR, filter.

Example 28 may include the subject matter of example 27, further includes a combiner configured to combine outputs of the first amplifier circuit and the second amplifier circuit to generate the filtered signals.

Example 29 may include the subject matter of any one of examples 16 to 28, further may include a controller configured to control the linear interpolator based on a Tx-FIR response configured for a transmission.

Example 30 may include the subject matter of a method that may include: generating a first output signal by sampling a phase modulation command signal using a first digital-to-time converter (DTC); generating a second output signal based on the phase modulation command signal using a second DTC, wherein the second output signal is generated with a programmable delay relative to the first output signal; and inverting a phase of one of the first output signal or the second output signal using a phase inverter.

Example 31 may include the subject matter of example 30, further may include: generating the first output signal by sampling with a sampling frequency; and configuring the programmable delay to be a fraction of a sampling period corresponding to the sampling frequency.

Example 32 may include the subject matter of example 30 or example 31, wherein the second output signal is generated as a shifted version of the first output signal by applying a fractional delay to the first output signal.

Example 33 may include the subject matter of any one of examples 30 to 32, further may include: generating the second output signal by sampling a delayed version of the phase modulation command signal using the second DTC.

Example 34 may include the subject matter of any one of examples 30 to 33, further may include: configuring the programmable delay to be selectable from a plurality of fractional values.

Example 35 may include the subject matter of any one of examples 30 to 34, further may include: adjusting the programmable delay using a controller.

Example 36 may include the subject matter of any one of examples 30 to 35, further may include: applying the programmable delay to the phase modulation command signal using a delay circuit coupled to the second DTC, wherein the programmable delay is applied based on a received oversampled oscillator signal.

Example 37 may include the subject matter of example 36, wherein the delay circuit includes a shift register configured to implement the programmable delay.

Example 38 may include the subject matter of any one of examples 30 to 37, further may include: amplifying the first output signal based on an amplitude modulation command signal using a first amplifier circuit coupled to the first DTC; and amplifying the second output signal based on a delayed version of the amplitude modulation command signal using a second amplifier circuit coupled to the second DTC.

Example 39 may include the subject matter of example 38, wherein amplifying the first or second output signal further includes: receiving the first output signal or the second output signal and the amplitude modulation command signal at an input terminal of the respective amplifier circuit; providing an amplified output signal at an output terminal coupled to the input terminal via a signal path; and configuring the signal path to include an XNOR gate, wherein the XNOR gate: receives the first output signal or the second output signal at a first gate input terminal; receives a control signal at a second gate input terminal, wherein the control signal represents whether to invert the phase of the first output signal or the second output signal; and outputs a phase-inverted signal at a gate output terminal.

Example 40 may include the subject matter of example 39, wherein the control signal is representative of a state of at least one of: an enablement of a fractional delay configuration; and/or a disablement of the fractional delay configuration for an integer delay configuration.

Example 41 may include the subject matter of any one of examples 38 to 40, further may include: applying the programmable delay to the amplitude modulation command signal using an amplifier delay circuit coupled to the second amplifier circuit.

Example 42 may include the subject matter of example 41, wherein the amplifier delay circuit includes a further shift register.

Example 43 may include the subject matter of any one of examples 30 to 42, wherein the programmable delay is implemented to generate filtered signals in a transmitter finite impulse response (Tx-FIR) filter.

Example 44 may include the subject matter of example 43, further may include: combining outputs of the first amplifier circuit and the second amplifier circuit using a combiner to generate the filtered signals.

Example 45 may include the subject matter of a method that may include: generating a first output signal by sampling a phase modulation command signal using a first digital-to-time converter (DTC); introducing a fractional delay to the phase modulation command signal using a delay circuit may include a linear interpolator to obtain an interpolated phase modulation command signal; and generating a second output signal based on the interpolated phase modulation command signal using a second DTC.

Example 46 may include the subject matter of example 45, wherein the fractional delay introduced by the linear interpolator includes a fractional portion of a sampling period of the phase modulation command signal.

Example 47 may include the subject matter of example 45 or 46, further may include: generating an integer delay component for the phase modulation command signal using a shift register included in the delay circuit.

Example 48 may include the subject matter of example 47, further may include: combining the integer delay component from the shift register and the fractional delay component from the linear interpolator to produce the interpolated phase modulation command signal.

Example 49 may include the subject matter of any one of examples 45 to 48, further may include: calculating the interpolated phase modulation command signal using a weighted sum of adjacent samples of the phase modulation command signal.

Example 50 may include the subject matter of any one of examples 45 to 49, wherein the phase modulation command signal received by the delay circuit includes an oversampled phase modulation command signal generated at a sampling rate greater than twice a bandwidth of a baseband signal generated by a baseband processor, wherein the phase modulation command signal is generated based on the baseband signal.

Example 51 may include the subject matter of any one of examples 45 to 50, further may include: generating the first output signal and the second output signal with a delay between the first output signal and the second output signal, wherein the delay includes the fractional delay.

Example 52 may include the subject matter of any one of examples 45 to 51, further may include: amplifying the first output signal based on an amplitude modulation command signal using a first amplifier circuit; and amplifying the second output signal based on an interpolated amplitude modulation command signal using a second amplifier circuit.

Example 53 may include the subject matter of example 52, further may include: generating the interpolated amplitude modulation command signal using the delay circuit; and configuring a first time offset between the phase modulation command signal and the interpolated phase modulation command signal to correspond to a second time offset between the amplitude modulation command signal and the interpolated amplitude modulation command signal.

Example 54 may include the subject matter of example 52 or example 53, wherein the linear interpolator introduces the fractional delay relative to the amplitude modulation command signal to obtain the interpolated amplitude modulation command signal.

Example 55 may include the subject matter of any one of examples 45 to 54, further may include: unwrapping a phase of at least one of the phase modulation command signal using a phase unwrapper coupled to an input of the linear interpolator; and providing the phase-unwrapped signal to the linear interpolator.

Example 56 may include the subject matter of any one of examples 45 to 55, wherein the programmable delay is implemented to generate filtered signals in a transmitter finite impulse response (Tx-FIR) filter.

Example 57 may include the subject matter of example 56, further may include: combining outputs of the first amplifier circuit and the second amplifier circuit using a combiner to generate the filtered signals.

Example 58 may include the subject matter of any one of examples 45 to 57, further may include: controlling the linear interpolator based on a Tx-FIR response configured for a transmission.

Example 59 may include a non-transitory computer-readable medium including instructions which, if executed by a processor, cause a system to perform the subject matter of any one of examples 30 to 58.

The word "exemplary" is used herein to mean "serving as an example, instance, or illustration". Any embodiment or design described herein as "exemplary" is not necessarily to be construed as preferred or advantageous over other embodiments or designs.

The words "plurality" and "multiple" in the description or the claims expressly refer to a quantity greater than one. The terms "group (of)", "set [of]", "collection (of)", "series (of)", "sequence (of)", "grouping (of)", etc., and the like in the description or in the claims refer to a quantity equal to or greater than one, i.e. one or more. Any term expressed in plural form that does not expressly state "plurality" or "multiple" likewise refers to a quantity equal to or greater than one.

Any vector and/or matrix notation utilized herein is exemplary in nature and is employed solely for purposes of explanation. Accordingly, the apparatuses and methods described herein accompanied by vector and/or matrix notation are not limited to being implemented solely using vectors and/or matrices, and that the associated processes and computations may be equivalently performed with respect to sets, sequences, groups, etc., of data, observations, information, signals, samples, symbols, elements, etc.

As used herein, "memory" is understood as a non-transitory computer-readable medium in which data or information can be stored for retrieval. References to "memory" included herein may thus be understood as referring to volatile or non-volatile memory, including random access memory ("RAM"), read-only memory ("ROM"), flash memory, solid-state storage, magnetic tape, hard disk drive, optical drive, etc., or any combination thereof. Furthermore, registers, shift registers, processor registers, data buffers, etc., are also embraced herein by the term memory. A single component referred to as "memory" or "a memory" may be composed of more than one different type of memory, and thus may refer to a collective component including one or more types of memory. Any single memory component may be separated into multiple collectively equivalent memory components, and vice versa. Furthermore, while memory may be depicted as separate from one or more other components (such as in the drawings), memory may also be integrated with other components, such as on a common integrated chip or a controller with an embedded memory.

The term "software" refers to any type of executable instruction, including firmware.

In the context described herein, the term "process" may be used, for example, to indicate a method. Illustratively, any process described herein may be implemented as a method (e.g., a channel estimation process may be understood as a channel estimation method). Any process described herein may be implemented as a non-transitory computer readable medium including instructions configured, when executed, to cause one or more processors to carry out the process (e.g., to carry out the method).

Throughout the drawings, it should be noted that like reference numbers are used to depict the same or similar elements, features, and structures, unless otherwise noted. It should be noted that certain components may be omitted for the sake of simplicity. It should be noted that nodes (dots) are provided to identify the circuit line intersections in the drawings including electronic circuit diagrams.

The phrase "at least one" and "one or more" may be understood to include a numerical quantity greater than or equal to one (e.g., one, two, three, four, [...], etc.). The phrase "at least one of" with regard to a group of elements may be used herein to mean at least one element from the group consisting of the elements. For example, the phrase "at least one of" with regard to a group of elements may be used herein to mean a selection of: one of the listed elements, a plurality of one of the listed elements, a plurality of individual listed elements, or a plurality of a multiple of individual listed elements.

The words "plural" and "multiple" in the description and in the claims expressly refer to a quantity greater than one. Accordingly, any phrases explicitly invoking the aforementioned words (e.g., "plural [elements]", "multiple [elements]") referring to a quantity of elements expressly refers to more than one of the said elements. For instance, the phrase "a plurality" may be understood to include a numerical quantity greater than or equal to two (e.g., two, three, four, five, [...], etc.).

As used herein, a signal or information that is "indicative of", "representative", "representing", or "indicating" a value or other information may be a digital or analog signal that encodes or otherwise, communicates the value or other information in a manner that can be decoded by and/or cause a responsive action in a component receiving the signal. The signal may be stored or buffered in computer-readable storage medium prior to its receipt by the receiving component and the receiving component may retrieve the signal from the storage medium. Further, a "value" that is "indicative of "or "representative" some quantity, state, or parameter may be physically embodied as a digital signal, an analog signal, or stored bits that encode or otherwise communicate the value.

As used herein, a signal may be transmitted or conducted through a signal chain in which the signal is processed to change characteristics such as phase, amplitude, frequency, and so on. The signal may be referred to as the same signal even as such characteristics are adapted. In general, so long as a signal continues to encode the same information, the signal may be considered as the same signal. For example, a transmit signal may be considered as referring to the transmit signal in baseband, intermediate, and radio frequencies.

The terms "processor" or "controller" as, for example, used herein may be understood as any kind of technological entity that allows handling of data. The data may be handled according to one or more specific functions executed by the processor. Further, a processor or controller as used herein may be understood as any kind of circuit, e.g., any kind of analog or digital circuit. A processor or a controller may thus be or include an analog circuit, digital circuit, mixed-signal circuit, logic circuit, processor, microprocessor, Central Processing Unit (CPU), Graphics Processing Unit (GPU), Digital Signal Processor (DSP), Field Programmable Gate Array (FPGA), integrated circuit, Application Specific Integrated Circuit (ASIC), etc., or any combination thereof. Any other kind of implementation of the respective functions, which will be described below in further detail, may also be understood as a processor, controller, or logic circuit. It is understood that any two (or more) of the processors, controllers, or logic circuits detailed herein may be realized as a single entity with equivalent functionality or the like, and conversely that any single processor, controller, or logic circuit detailed herein may be realized as two (or more) separate entities with equivalent functionality or the like.

The terms "one or more processors" is intended to refer to a processor or a controller. The one or more processors may include one processor or a plurality of processors. The terms are simply used as an alternative to the "processor" or "controller".

The term "user device" is intended to refer to a device of a user (e.g. occupant) that may be configured to provide information related to the user. The user device may exemplarily include a mobile phone, a smart phone, a wearable device (e.g. smart watch, smart wristband), a computer, etc.

As utilized herein, terms "module", "component," "system," "circuit," "element," "slice," " circuit," and the like are intended to refer to a set of one or more electronic components, a computer-related entity, hardware, software (e.g., in execution), and/or firmware. For example, circuit or a similar term can be a processor, a process running on a processor, a controller, an object, an executable program, a storage device, and/or a computer with a processing device. By way of illustration, an application running on a server and the server can also be circuit. One or more circuits can reside within the same circuit, and circuit can be localized on one computer and/or distributed between two or more computers. A set of elements or a set of other circuits can be described herein, in which the term "set" can be interpreted as "one or more".

The term "data" as used herein may be understood to include information in any suitable analog or digital form, e.g., provided as a file, a portion of a file, a set of files, a signal or stream, a portion of a signal or stream, a set of signals or streams, and the like. Further, the term "data" may also be used to mean a reference to information, e.g., in form of a pointer. The term "data", however, is not limited to the aforementioned examples and may take various forms and represent any information as understood in the art. The term "data item" may include data or a portion of data.

It will be understood that when an element is referred to as being "connected" or "coupled" to another element, it can be physically connected or coupled to the other element such that current and/or electromagnetic radiation (e.g., a signal) can flow along a conductive path formed by the elements. Inherently, such element is connectable or couplable to the another element. Intervening conductive, inductive, or capacitive elements may be present between the element and the other element when the elements are described as being coupled or connected to one another. Further, when coupled or connected to one another, one element may be capable of inducing a voltage or current flow or propagation of an electro-magnetic wave in the other element without physical contact or intervening components. Further, when a voltage, current, or signal is referred to as being "provided" to an element, the voltage, current, or signal may be conducted to the element by way of a physical connection or by way of capacitive, electro-magnetic, or inductive coupling that does not involve a physical connection.

Unless explicitly specified, the term "instance of time" refers to a time of a particular event or situation according to the context. The instance of time may refer to an instantaneous point in time, or to a period of time which the particular event or situation relates to.

Unless explicitly specified, the term "transmit" encompasses both direct (point-to-point) and indirect transmission (via one or more intermediary points). Similarly, the term "receive" encompasses both direct and indirect reception. Furthermore, the terms "transmit," "receive," "communicate," and other similar terms encompass both physical transmission (e.g., the transmission of radio signals) and logical transmission (e.g., the transmission of digital data over a logical software-level connection). For example, a processor or controller may transmit or receive data over a software-level connection with another processor or controller in the form of radio signals, where the physical transmission and reception is handled by radio-layer components such as RF transceivers and antennas, and the logical transmission and reception over the software-level connection is performed by the processors or controllers. The term "communicate" encompasses one or both of transmitting and receiving, i.e., unidirectional or bidirectional communication in one or both of the incoming and outgoing directions. The term "calculate" encompasses both 'direct' calculations via a mathematical expression/formula/relationship and 'indirect' calculations via lookup or hash tables and other array indexing or searching operations.

While the above descriptions and connected figures may depict electronic device components as separate elements, skilled persons will appreciate the various possibilities to combine or integrate discrete elements into a single element. Such may include combining two or more circuits to form a single circuit, mounting two or more circuits onto a common chip or chassis to form an integrated element, executing discrete software components on a common processor core, etc. Conversely, skilled persons will recognize the possibility to separate a single element into two or more discrete elements, such as splitting a single circuit into two or more separate circuits, separating a chip or chassis into discrete elements originally provided thereon, separating a software component into two or more sections and executing each on a separate processor core, etc.

It is appreciated that implementations of methods detailed herein are demonstrative in nature, and are thus understood as capable of being implemented in a corresponding device. Likewise, it is appreciated that implementations of devices detailed herein are understood as capable of being implemented as a corresponding method. It is thus understood that a device corresponding to a method detailed herein may include one or more components configured to perform each aspect of the related method. All acronyms defined in the above description additionally hold in all claims included herein.

## Claims

1. A circuitry comprising:
a first digital-to-time converter, DTC, configured to generate a first output signal by sampling a phase modulation command signal;
a second DTC configured to generate a second output signal based on the phase modulation command signal with a programmable delay relative to the first output signal; and
a phase inverter configured to invert a phase of one of the first output signal or the second output signal.

2. The circuitry of claim 1, wherein the first DTC is configured to generate the first output signal by sampling with a sampling frequency; and
wherein an amount of the programmable delay is a fraction of a sampling period corresponding to the sampling frequency.

3. The circuitry of claim 1 or claim 2, wherein the second output signal is a shifted first output signal representing the first output signal that has been shifted in time with a fractional number of samples.

4. The circuitry of any one of claims 1 to 3, wherein the second DTC is configured to generate the second output signal by sampling a delayed version of the phase modulation command signal.

5. The circuitry of any one of claims 1 to 4, wherein the programmable delay is configurable to a plurality of fractional values.

6. The circuitry of any one of claims 1 to 5, further comprising a delay circuit coupled to the second DTC; and
wherein the delay circuit is configured to apply the programmable delay based on a received oversampled oscillator signal to the phase modulation command signal.

7. The circuitry of claim 6, wherein the delay circuit comprises a shift register.

8. The circuitry of any one of claims 1 to 7, further comprising:
a first amplifier circuit coupled to the first DTC and configured to amplify the first output signal based on an amplitude modulation command signal; and
a second amplifier circuit coupled to the second DTC and configured to amplify the second output signal based on a delayed version of the amplitude modulation command signal.

9. The circuitry of claim 8, wherein the first amplifier circuit or the second amplifier circuit comprises:
an input terminal configured to receive the first output signal and the amplitude modulation command signal;
an output terminal coupled to the input terminal via a signal path to provide a respective first amplified output signal or a second amplified output signal;
wherein the signal path comprises an XNOR gate comprising:
a first gate input terminal coupled to the input terminal;
a second gate input terminal configured to receive a control signal representing whether to invert the phase of the first output signal or the second output signal; and
a gate output terminal coupled to the output terminal.

10. The circuitry of any one of claims 8 or 9, further comprising an amplifier delay circuit coupled to the second amplifier circuit;
wherein the amplifier delay circuit is configured to apply the programmable delay based on a received oversampled oscillator signal to the amplifier modulation command signal.

11. The circuitry of any one of claims 1 to 10, wherein the programmable delay is implemented to generate filtered signals in a transmitter finite impulse response, Tx-FIR, filter.

12. The circuitry of claim 11, further comprises a combiner configured to combine outputs of the first amplifier circuit and the second amplifier circuit to generate the filtered signals.

13. The circuitry of any one of claims 1 to 12, further comprises a linear interpolator configured to introduce a fractional delay to a received phase modulation command signal and/or a received amplitude modulation command signal.

14. A method comprising:
generating a first output signal by sampling a phase modulation command signal using a first digital-to-time converter (DTC);
generating a second output signal based on the phase modulation command signal using a second DTC, wherein the second output signal is generated with a programmable delay relative to the first output signal; and
inverting a phase of one of the first output signal or the second output signal using a phase inverter.

15. A non-transitory computer-readable medium comprising instructions which, if executed by a processor, cause a system to perform the method of claim 14.
